(19) Europäisches Patentamt
European Patent Office
Office européen des brevets

(11) **EP 1 920 535 B1**

(12) **EUROPÄISCHE PATENTSCHRIFT**

(45) Veröffentlichungstag und Bekanntmachung des Hinweises auf die Patenterteilung:
**08.01.2014 Patentblatt 2014/02**

(51) Int Cl.:
*H03L 1/02* *(2006.01)*　　*H03L 7/099* *(2006.01)*
*H03K 3/0231* *(2006.01)*

(21) Anmeldenummer: 06777155.0

(22) Anmeldetag: **02.09.2006**

(86) Internationale Anmeldenummer:
**PCT/EP2006/008588**

(87) Internationale Veröffentlichungsnummer:
**WO 2007/025777 (08.03.2007 Gazette 2007/10)**

(54) **OSZILLATORSCHALTUNG SOWIE VERFAHREN ZUR BEEINFLUSSUNG, STEUERUNG ODER REGELUNG DER FREQUENZ EINES OSZILLATORS**

OSCILLATOR CIRCUIT AND METHOD FOR INFLUENCING, CONTROLLING, OR REGULATING THE FREQUENCY OF AN OSCILLATOR

CIRCUIT D'OSCILLATEUR ET PROCEDE DESTINE A INFLUENCER COMMANDER OU REGULER LA FREQUENCE D'UN OSCILLATEUR

(84) Benannte Vertragsstaaten:
**AT BE BG CH CY CZ DE DK EE ES FI FR GB GR HU IE IS IT LI LT LU LV MC NL PL PT RO SE SI SK TR**

(30) Priorität: **02.09.2005 DE 102005041759**

(43) Veröffentlichungstag der Anmeldung:
**14.05.2008 Patentblatt 2008/20**

(73) Patentinhaber: **Pepperl + Fuchs GmbH**
**68307 Mannheim (DE)**

(72) Erfinder: **GAEDE, Dirk**
**68309 Mannheim (DE)**

(74) Vertreter: **Mierswa, Klaus**
**MIERSWA &VONNEMANN**
**Patentanwälte**
**Postfach 10 25 52**
**68025 Mannheim (DE)**

(56) Entgegenhaltungen:
**EP-A2- 0 310 783　　WO-A-85/02076**
**DE-A1- 4 033 025　　US-A- 3 688 220**
**US-A- 4 631 501**

• **TSIVIDIS Y ET AL: "CONTINUOUS-TIME MOSFET-C FILTERS IN VLSI" IEEE JOURNAL OF SOLID-STATE CIRCUITS, IEEE SERVICE CENTER, PISCATAWAY, NJ, US, Bd. SC-21, Nr. 1, 1. Februar 1986 (1986-02-01), Seiten 15-30, XP000577205 ISSN: 0018-9200**

**Beschreibung**

Technisches Gebiet:

Die Erfindung betrifft eine Oszillatorschaltung sowie ein Verfahren zur Beeinflussung, Steuerung oder Regelung der Frequenz eines Oszillators.

Stand der Technik:

Die Laufzeit eines ausgesendeten und rückreflektierten elektromagnetischen oder akustischen Signals wird in vielen Bereichen der Technik für Ortung und Entfernungsbestimmung von Objekten eingesetzt. Grundlage dafür ist die bei konstanter Ausbreitungsgeschwindigkeit des Signals lineare Beziehung zwischen der Laufzeit des Signals und der zurückgelegten Strecke, damit auch der Entfernung des Objekts. Schall-Laufzeitmessungen werden beispielsweise ausgenutzt beim Echotot-Verfahren, in medizinischen Ultraschall-Diagnosegeräten, bei der Überwachung von Füllständen von Medien in Behältnissen oder in automatisch ablaufenden Fertigungsprozessen.

Die benötigten akustischen Signale werden meist durch Ultraschall-Wandler erzeugt. Bevorzugt werden als Ultraschall-Wandler spezielle Keramiken verwendet, welche durch Anlegen einer Wechselspannung mit Hilfe des piezoelektrischen Effekts zu mechanischen Schwingungen und damit zur Abgabe von Ultraschall angeregt werden.

Um eine möglichst hohe Leistung der von dem Ultraschall-Wandler erzeugten Ultraschallwellen zu erzielen, sollte die Frequenz der verwendeten Wechselspannung mit der Eigenfrequenz, d.h. mit der Resonanzfrequenz des Ultraschall-Wandlers identisch sein. In der Praxis wird daher üblicherweise die Frequenz der Wechselspannung auf die Resonanzfrequenz des Ultraschall-Wandlers abgestimmt.

Die Wechselspannung wird üblicherweise durch einen Oszillator erzeugt und anschließend durch einen oder mehrere Treiber auf die zur Anregung des Ultraschallwandlers erforderliche Leistung verstärkt.

Jedoch ist die Resonanzfrequenz von Ultraschallwandlern nicht konstant; vielmehr ist sie z.B. auf Grund von Alterung, Verschmutzung und Temperaturdrift des Ultraschall-Wandlers zeitlichen Änderungen unterworfen, welche ein erhebliches Ausmaß erreichen können; um der Temperaturdrift zu begegnen, sind spezielle Kompensationsschaltungen entwickelt worden. Einen weiteren Einflussfaktor auf die Resonanzfrequenz des Ultraschall-Wandlers stellen dessen Einbaubedingungen im Betrieb dar.

Des weiteren können Exemplarstreuungen der Resonanzfrequenz eine störende Rolle spielen, z.B. dann, wenn ein Ultraschall-Wandler in einem akustischen Abstands-Meßsystem aufgrund eines Defekts gegen einen anderen Ultraschall-Wandler ausgetauscht werden muss. In solchen Fällen muss auf Grund der üblichen Exemplarstreuung meist eine Neuabstimmung der anregenden Wechselspannung erfolgen, was einen erheblichen Zusatzaufwand und entsprechende Kosten bedeuten kann.

Um langfristig eine maximale Schalleistung zu erzielen, muss die Änderung der Resonanzfrequenz des Ultraschallwandlers durch Nachstimmen der Oszillatorfrequenz ausgeglichen werden.

Zur Abstimmung der Frequenz der Wechselspannung auf die Resonanzfrequenz des Ultraschall-Wandlers sind verschiedene Verfahren bekannt.

Eines dieser Verfahren ist Direct Digital Synthesis (DDS). Nachteilig hierbei sind die hohen Kosten des DDS-IC. Ein weiterer Nachteil dieses Verfahrens besteht in dem Umstand, dass das Frequenzsignal meist als kontinuierliche, harmonische Kleinsignalschwingung vorliegt und zusätzlich aufbereitet werden muss (Verstärkung, Rechteckformung, Torschaltung für Anregungsdauer).

Ein anderes bekanntes Verfahren ist die Verwendung einer Kombination aus Digital-Analog-Konverter (DAC) und analog steuerbarem Oszillator (VCO). Dieses Verfahren ist aufwendig, wenn ein externer DAC verwendet wird.

Zur Ultraschall-Laufzeitmessung wird dann ein weiterer Timer benötigt, wodurch der Spielraum bei der Programmierung insbesondere bei Verwendung von einfachen 8-Bit-Mikrocontrollern erheblich eingeschränkt wird.

Ferner ist bei diesem Verfahren nachteilig, dass der VCO zusätzlich in einem geschlossenen Regelkreis betrieben werden muss, da die Steuerkennlinie eines gewöhnlichen VCO-IC aufgrund von Exemplarstreuungen und geringer Konstanz als Frequenzmaßstab ungeeignet ist.

Ein weiteres bekanntes Verfahren besteht in der Frequenzerzeugung durch den Mikrocontroller selbst (per software loop oder mittels Timer). Hierbei wird jedoch nur eine unzureichende Frequenzauflösung von typischerweise ca. 10% erreicht (z.B. Mikrocontroller-Taktfrequenz 4 MHz, Ultraschall-Wandler-Resonanzfrequenz 400 kHz), gefordert bzw. wünschenswert ist jedoch eine Frequenzauflösung von ca. 0,2%. Weitere Nachteile sind, dass dieses Verfahren nur mit darauf abgestimmten Ultraschall-Wandlern geringster Fertigungstoleranz oder unter Inkaufnahme eines gravierenden Performance-Verlustes realisierbar ist und dass eine Temperaturkompensation nicht ohne weiteres möglich ist.

Ein weiteres Verfahren besteht in der Verwendung eines digitalen Potentiometers als Abgleichelement. Eine ausreichende Frequenzauflösung wäre dabei mit höheren Kosten verbunden.

Ein weiteres Verfahren besteht in der Verwendung eines RC-Oszillators mit Laserabgleich des frequenzbestimmenden Widerstandes. Sehr nachteilig hierbei ist, dass nur ein einmaliger Abgleich in eine Richtung (abnehmende Frequenz) möglich ist.

Ein weiteres Verfahren besteht in einem Abgleich mittels eines mechanischen Potentiometers oder Trimmer-Kondensators. Dieses Verfahren erfordert entweder einen hohen Personal- und Zeitaufwand oder spezielles Equipment, welches nur bei hohen Stückzahlen rentabel ist. Ein weiterer Nachteil dieses Verfahrens ist das mechanische Rückfedern des Abgleichelements, die Frequenz kann sich kurz nach dem Abgleich oder später von selbst wieder verändern.

Den beiden letztgenannten Verfahren haften ferner die Nachteile an, dass eine Verstimmung der Oszillatorschaltung durch den Verguss der Elektronik mit Gießharz ($\varepsilon_\gamma$ = 2..3) möglich ist und dass die Frequenz nicht per Software gesteuert werden kann.

Aus US 3,688,220 ist eine Oszillatorschaltung mit Kippschaltung und RC Verzögerungsglied bekannt, dessen Frequenz mittels einen steuerbaren Widerstand abgestimmt werden kann.

Der Erfindung liegt daher die Aufgabe zu Grunde, eine Oszillatorschaltung sowie ein Verfahren zur Beeinflussung, Steuerung oder Regelung der Frequenz eines Oszillators anzugeben, welche mit einem sehr geringen schaltungstechnischen Aufwand eine präzise Veränderung der Frequenz mit hoher Auslösung erlauben, wobei auf einfache Weise, ohne Übertragung von Datenworten an den Oszillator, mit ebenso hoher Präzision und Auflösung auch eine Einstellung der Frequenz per Software möglich sein soll.

Diese Aufgabe wird erfindungsgemäß gelöst durch eine Oszillatorschaltung, mit einem Oszillator, welcher eine Kippschaltung, z.B. Schmitt-Trigger oder Multivibrator oder Relaxationsoszillator oder Verstärkerschaltung mit HystereseVerhalten, mit einem Ausgang und einem invertierenden Eingang umfaßt, wobei der Ausgang über einen Rückkopplungswiderstand mit dem invertierenden Eingang verbunden ist, der invertierende Eingang über einen ersten Oszillator-Kondensator an ein erstes Potential gelegt ist, der invertierende Eingang ferner über einen zweiten Oszillator-Kondensator und einen mit diesem in Serie geschalteten Steuerwiderstand, dessen Wert einstellbar oder elektrisch steuerbar ist, an ein zweites Potential gelegt ist, so dass die Frequenz des Oszillators durch Verändern des Wertes des Steuerwiderstandes veränderbar ist.

Die Aufgabe wird ferner gelöst durch ein Verfahren zur Steuerung oder Regelung der Frequenz eines Oszillators, wobei als Oszillator ein solcher verwendet wird, welcher eine Kippschaltung, z.B. Schmitt-Trigger oder Multivibrator oder Relaxationsoszillator oder Verstärkerschaltung mit HystereseVerhalten, mit einem Ausgang und einem invertierenden Eingang umfaßt, der Ausgang über einen Rückkopplungswiderstand mit dem invertierenden Eingang verbunden ist, der invertierende Eingang über einen ersten Oszillator-Kondensator an ein erstes Potential gelegt ist, der invertierende Eingang ferner über einen zweiten Oszillator-Kondensator und einen mit diesem in Serie geschalteten Steuerwiderstand, dessen Wert einstellbar oder elektrisch steuerbar ist, an ein zweites Potential gelegt ist, und die Frequenz des Oszillators durch Verändern des Wertes des Steuerwiderstandes verändert wird.

Das erste Potential kann mit dem zweiten Potential identisch sein. Das erste und/oder das zweite Potential können feste, d.h. zeitlich konstante Potentiale, insbesondere Masse, sein. Ein Vorteil einer solchen Oszillatorschaltung gegenüber bekannten Oszillatorschaltungen nach dem Prinzip des Relaxationsoszillators ist, dass der Steuerwiderstand auf ein festes Potential, z. B. Masse, bezogen sein kann und damit besonders einfach elektronisch ansteuerbar ist.

Gemäß einer Ausführungsform ist der Steuerwiderstand, anstatt direkt an das zweite Potential gelegt zu sein, über eine zwischengeschaltete Spannungsquelle an das zweite Potential gelegt, und/oder der erste Oszillatorkondensator, anstatt direkt an das erste Potential gelegt zu sein, über eine zwischengeschaltete Spannungsquelle an das erste Potential gelegt.

Daher wird gemäß einer Variante des Verfahrens als Steuerwiderstand ein solcher verwendet, welcher, anstatt direkt an das zweite Potential gelegt zu sein, über eine zwischengeschaltete Spannungsquelle an das zweite Potential gelegt ist, und/oder als erster Oszillatorkondensator ein solcher verwendet, welcher, anstatt direkt an das erste Potential gelegt zu sein, über eine zwischengeschaltete Spannungsquelle an das erste Potential gelegt ist.

Insbesondere können der erste und/oder der zweite Oszillator-Kondensator und/oder der Steuerwiderstand gleichspannungsmäßig an jeweils ein beliebiges Potential gelegt, wechselspannungsmäßig jedoch an Masse gelegt sein.

Bevorzugt ist der Steuerwiderstand durch die Kollektor-Emitter-Strecke bzw. die Drain-Source-Strecke eines Transistors, im folgenden als Steuertransistor bezeichnet, gebildet, an dessen Basis bzw. Gate eine Steuerspannung anliegt, so dass der zweite Oszillator-Kondensator über die Kollektor-Emitter-Strecke bzw. die Drain-Source-Strecke des Steuertransistors an das zweite Potential, insbesondere an Masse, gelegt ist, und die Frequenz des Oszillators durch Verändern der Steuerspannung veränderbar ist.

Gemäß einer alternativen Ausführungsform ist der Steuerwiderstand durch die Kollektor-Emitter-Strecke eines als Steuertransistor bezeichneten Transistors gebildet, durch dessen Basis ein Steuerstrom fließt, so dass der zweite Oszillator-Kondensator über die Kollektor-Emitter-Strecke des Steuertransistors an das zweite Potential, insbesondere an Masse, gelegt ist, und die Frequenz des Oszillators durch Verändern des Steuerstromes veränderbar ist.

Als Steuerwiderstand wird bevorzugt die Kollektor-Emitter-Strecke bzw. die Drain-Source-Strecke eines Transistors, der im folgenden als Steuertransistor bezeichnet wird, verwendet, so dass der zweite Oszillator-Kondensator über die Kollektor-Emitter-Strecke bzw. die Drain-Source-Strecke des Steuertransistors an das zweite Potential, insbe-

EP 1 920 535 B1

sondere an Masse, gelegt ist, wobei an die Basis bzw. das Gate des Steuertransistors eine Steuerspannung angelegt wird, und die Frequenz des Oszillators durch Verändern der Steuerspannung verändert wird.

Gemäß einer alternativen Verfahrensvariante wird als Steuerwiderstand die Kollektor-Emitter-Strecke eines Transistors, Steuertransistor, verwendet, durch dessen Basis ein Steuerstrom fließt, so dass der zweite Oszillator-Kondensator über die Kollektor-Emitter-Strecke des Steuertransistors an das zweite Potential, insbesondere an Masse, gelegt ist, und die Frequenz des Oszillators durch Verändern des Steuerstromes verändert.

Gemäß einer Variante ist der Kollektor bzw. der Drain-Anschluss mit dem zweiten Oszillator-Kondensator und der Emitter bzw. der Source-Anschluss mit dem zweiten Potential verbunden. Gemäß einer hiervon abweichenden anderen vorteilhaften Variante ist die Kollektor-Emitter-Strecke bzw. die Drain-Source-Strecke des Steuertransistors invers zwischen den zweiten Oszillator-Kondensator und das zweite Potential zwischengeschaltet, also der Emitter bzw. der Source-Anschluss mit dem zweiten Oszillator-Kondensator und der Kollektor bzw. der Drain-Anschluss mit dem zweiten Potential verbunden. Verfahrensmäßig wird somit die Kollektor-Emitter-Strecke bzw. die Drain-Source-Strecke des Steuertransistors invers betrieben. Durch inverses Betreiben des Steuertransistors kann ein verbessertes Anlaufverhalten des Oszillators erreicht werden.

Der Steuertransistor braucht nicht notwendigerweise in Emitter- bzw. Source-Schaltung betrieben zu werden. Er kann statt dessen z.B. in Basis- bzw. Gate-Schaltung betrieben werden. Gemäß einer Variante ist daher der Steuerwiderstand durch die Kollektor-Emitter-Strecke bzw. die Drain-Source-Strecke eines Transistors, Steuertransistor, gebildet, an dessen Emitter bzw. Source eine Steuerspannung anliegt und dessen Basis bzw. Gate an ein drittes Potential gelegt ist, so dass der zweite Oszillator-Kondensator über die Kollektor-Emitter-Strecke bzw. die Drain-Source-Strecke des Steuertransistors an die Steuerspannung gelegt ist und somit der Steuertransistor in Basisschaltung bzw. Gate-Schaltung angeschlossen ist, und die Frequenz des Oszillators durch Verändern der Steuerspannung veränderbar ist. In diesem Fall sind die Steuerspannung und das zweite Potential miteinander identisch.

Der Steuerwiderstand kann durch die Kollektor-Emitter-Strecke bzw. die Drain-Source-Strecke eines Transistors, Steuertransistor, gebildet sein, an dessen Emitter bzw. Source eine Steuerspannung angelegt wird und dessen Basis bzw. Gate an ein drittes Potential gelegt ist, so dass der zweite Oszillator-Kondensator über die Kollektor-Emitter-Strecke bzw. die Drain-Source-Strecke des Steuertransistors an das zweite Potential gelegt ist und somit der Steuertransistor in Basisschaltung bzw. Gate-Schaltung betrieben wird, wobei die Frequenz des Oszillators durch Verändern der Steuerspannung verändert wird. In diesem Fall sind die Steuerspannung und das zweite Potential miteinander identisch.

Auch in Basisschaltung kann der Steuertransistor invers betrieben werden, d.h. Steuerspannung kann an den Kollektor bzw. den Drain-Anschluss angelegt sein und der zweite Oszillatorkondensator mit dem Emitter bzw. dem Source-Anschluss des Teuertransistors verbunden sein. Die Basis bzw. der Gate-Anschluss liegt dabei dem auf dem vorzugsweise festen dritten Potential.

Gemäß einer sehr vorteilhaften Ausgestaltung ist der Wert des Steuerwiderstandes und damit die Frequenz des Oszillators über ein moduliertes 1-Bit-Signal, insbesondere über eine Pulsweitenmodulation, beeinflussbar, steuerbar oder regelbar. Gemäß einer Variante des Verfahrens werden daher der Wert des Steuerwiderstandes und damit die Frequenz des Oszillators über ein moduliertes 1-Bit-Signal, insbesondere über eine Pulsweitenmodulation, beeinflusst, gesteuert oder geregelt.

Falls als Steuerwiderstand z.B. die Kollektor-Emitter-Strecke bzw. die Drain-Source-Strecke eines Steuertransistors zum Einsatz kommt, kann die Steuerspannung und damit die Frequenz des Oszillators besonders vorteilhaft über ein moduliertes 1-Bit-Signal, insbesondere über eine Pulsweitenmodulation, beeinflussbar, steuerbar oder regelbar sein. Verfahrensmäßig können daher die Steuerspannung und damit die Frequenz des Oszillators über ein moduliertes 1-Bit-Signal, insbesondere über eine Pulsweitenmodulation, beeinflusst, gesteuert oder geregelt werden.

Gemäß einer bevorzugten Variante wird als Steuertransistor ein solcher verwendet, dessen Basis bzw. Gate mit dem Ausgang eines Integrators verbunden ist, dessen Eingang mit dem Ansteuerausgang einer Ansteuerschaltung verbunden ist, wobei

- als Ansteuerschaltung eine solche verwendet wird, welche über den Ansteuerausgang ein Ansteuersignal an den Eingang des Integrators abzugeben imstande ist, welches entweder gleich oder kleiner ist als ein erster Spannungswert oder gleich oder größer ist als ein zweiter Spannungswert, wobei der erste Spannungswert kleiner ist als der zweite Spannungswert, und
- als Integrator ein solcher verwendet wird, welcher das Ansteuersignal zu der Steuerspannung zu integrieren und diese über den Ausgang des Integrators an die Basis bzw. das Gate des Steuertransistors abzugeben imstande ist,

und wobei entweder

- die Steuerspannung verringerbar ist, indem die Ansteuerschaltung so gesteuert wird, dass das Ansteuersignal gleich oder kleiner ist als der erste Spannungswert,

4

- und die Steuerspannung erhöhbar ist, indem die Ansteuerschaltung so gesteuert wird, dass das Ansteuersignal gleich oder größer ist als der zweite Spannungswert,

oder umgekehrt, so dass die Frequenz des Oszillators oder deren Änderungsgeschwindigkeit durch das Ansteuersignal beeinflusst oder gesteuert wird.

Hierbei sind verschiedene Fälle möglich:

(i) Falls der Integrator ein nicht-invertierender Integrator ist und der Oszillator ein solcher ist, dessen Frequenz mit steigender Steuerspannung zunimmt, wird die Steuerspannung verringert und somit die Frequenz des Oszillators ebenfalls verringert, indem die Ansteuerschaltung so gesteuert wird, dass das Ansteuersignal gleich oder kleiner ist als der erste Spannungswert, und die Steuerspannung erhöht und somit die Frequenz des Oszillators ebenfalls erhöht, indem die Ansteuerschaltung so gesteuert wird, dass das Ansteuersignal gleich oder größer ist als der zweite Spannungswert.

(ii) Falls der Integrator ein nicht-invertierender Integrator ist und der Oszillator ein solcher ist, dessen Frequenz mit steigender Steuerspannung abnimmt, wird die Steuerspannung verringert und somit die Frequenz des Oszillators erhöht, indem die Ansteuerschaltung so gesteuert wird, dass das Ansteuersignal gleich oder kleiner ist als der erste Spannungswert, und die Steuerspannung erhöht und somit die Frequenz des Oszillators verringert, indem die Ansteuerschaltung so gesteuert wird, dass das Ansteuersignal gleich oder größer ist als der zweite Spannungswert,

(iii) Falls der Integrator ein invertierender Integrator ist und der Oszillator ein solcher ist, dessen Frequenz mit steigender Steuerspannung zunimmt, wird die Steuerspannung erhöht und somit die Frequenz des Oszillators ebenfalls erhöht, indem die Ansteuerschaltung so gesteuert wird, dass das Ansteuersignal gleich oder kleiner ist als der erste Spannungswert, und die Steuerspannung verringert und somit die Frequenz des Oszillators ebenfalls verringert, indem die Ansteuerschaltung so gesteuert wird, dass das Ansteuersignal gleich oder größer ist als der zweite Spannungswert.

(iv) Falls der Integrator ein invertierender Integrator ist und der Oszillator ein solcher ist, dessen Frequenz mit steigender Steuerspannung abnimmt, wird die Steuerspannung erhöht und somit die Frequenz des Oszillators verringert, indem die Ansteuerschaltung so gesteuert wird, dass das Ansteuersignal gleich oder kleiner ist als der erste Spannungswert, und die Steuerspannung verringert und somit die Frequenz des Oszillators erhöht, indem die Ansteuerschaltung so gesteuert wird, dass das Ansteuersignal gleich oder größer ist als der zweite Spannungswert.

Gemäß einer bevorzugten Variante der Oszillatorschaltung ist die Basis bzw. das Gate des Steuertransistors mit dem Ausgang eines Integrators verbunden, dessen Eingang mit dem Ansteuerausgang einer Ansteuerschaltung verbunden, wobei

- die Ansteuerschaltung über den Ansteuerausgang ein Ansteuersignal an den Eingang des Integrators abzugeben imstande ist, welches entweder gleich oder kleiner ist als ein erster Spannungswert oder gleich oder größer ist als ein zweiter Spannungswert, wobei der erste Spannungswert kleiner ist als der zweite Spannungswert, und
- der Integrator das Ansteuersignal zu der Steuerspannung zu integrieren und diese über den Ausgang des Integrators an die Basis bzw. das Gate des Steuertransistors abzugeben imstande ist,

so dass entweder die Steuerspannung dann abnimmt, wenn das Ansteuersignal gleich oder kleiner ist als der erste Spannungswert, und die Steuerspannung dann zunimmt, wenn das Ansteuersignal gleich oder größer ist als der zweite Spannungswert , oder umgekehrt, und somit die Frequenz des Oszillators oder deren Änderungsgeschwindigkeit durch das Ansteuersignal beeinflussbar oder steuerbar ist.

Gemäß einer Ausführungsform der Oszillatorschaltung ist das Ansteuersignal ein im weseritlichen rechteckförmig zwischen dem ersten und dem zweiten Spannungswert wechselndes pulsmoduliertes 1-Bit-Signal, so dass entweder die Steuerspannung verringerbar ist, indem der Mittelwert des Ansteuersignals durch entsprechendes Verändern der zeitlichen Abfolge des ersten und des zweiten Spannungswertes verkleinert wird, und die Steuerspannung erhöhbar ist, indem der Mittelwert des Ansteuersignals durch entsprechendes Verändern der zeitlichen Abfolge des ersten und des zweiten Spannungswertes vergrößert wird, oder - z.B. im Falle eines invertierenden Integrators - umgekehrt, und somit die Frequenz des Oszillators oder deren Änderungsgeschwindigkeit über das pulsmodulierte 1-Bit-Signal beeinflussbar oder steuerbar ist.

Gemäß einer Variante des Verfahrens wird daher als Ansteuersignal ein im wesentlichen rechteckförmig zwischen dem ersten und dem zweiten Spannungswert wechselndes pulsmoduliertes 1-Bit-Signal verwendet wird, so dass entweder die Steuerspannung verringerbar ist, indem der Mittelwert des Ansteuersignals durch entsprechendes Verändern der zeitlichen Abfolge des ersten und des zweiten Spannungswertes verkleinert wird, und die Steuerspannung erhöhbar ist, indem der Mittelwert des Ansteuersignals jeweils durch entsprechendes Verändern der zeitlichen Abfolge des ersten und des zweiten Spannungswertes vergrößert wird, oder - z.B. im Falle der Verwendung eines invertierenden Integrators - umgekehrt, und die Frequenz des Oszillators oder deren Änderungsgeschwindigkeit über das pulsmodulierte 1-Bit-Signal beeinflusst oder gesteuert wird, z.B. durch Verändern von dessen Mittelwert.

Insbesondere kann das Ansteuersignal ein im wesentlichen rechteckförmig mit einem veränderbaren Tastverhältnis zwischen dem ersten und dem zweiten Spannungswert wechselndes pulsmoduliertes 1-Bit-Signal sein, dessen Mittelwert durch entsprechendes Verändern des Tastverhältnisses veränderbar ist, so dass das pulsmodulierte 1-Bit-Signal zur Beeinflussung oder Steuerung der Frequenz ein pulsweitenmoduliertes Signal ist und somit die Frequenz des Oszillators oder deren Änderungsgeschwindigkeit durch eine Pulsweitenmodulation beeinflussbar oder steuerbar ist

Verfahrensmäßig kann daher als Ansteuersignal ein im wesentlichen rechteckförmig mit einem veränderbaren Tastverhältnis zwischen dem ersten und dem zweiten Spannungswert oszillierendes pulsmoduliertes 1-Bit-Signal verwendet werden, dessen Mittelwert durch entsprechendes Verändern des Tastverhältnisses veränderbar ist, so dass die Frequenz des Oszillators oder deren Änderungsgeschwindigkeit durch eine Pulsweitenmodulation beeinflusst oder gesteuert wird.

Bevorzugt ist das Tastverhältnis stufenlos oder in kleinen Schritten zwischen 0% und 100% veränderbar, so dass die Änderungsrate der Steuerspannung durch entsprechende Wahl des Tastverhältnisses gewählt bzw. beeinflusst werden kann.

Der Integrator umfaßt gemäß einer besonders einfachen Ausführungsform folgende Bauteile:

- einen ersten Integrator-Widerstand, welcher zwischen den Ansteuerausgang und die Basis bzw. das Gate des Steuertransistors zwischengeschaltet ist, und
- einen ersten Integrator-Kondensator, über welchen die Basis bzw. das Gate des Steuertransistors an ein vorzugsweise festes Potential, insbesondere an Masse, gelegt ist.

Das feste Potential braucht nicht notwendigerweise mit dem ersten oder zweiten festen Potential identisch zu sein.

Gemäß einer anderen Ausführungsform umfaßt der Integrator folgende Bauteile:

- einen Integrator-Transistor,
- einen zweiten Integrator-Widerstand,
- einen ersten Vorwiderstand,
- einen zweiten Integrator-Kondensator sowie
- eine externe Zusatzspannungsquelle

wobei

- der zweite Integrator-Widerstand zwischen den Ansteuerausgang und die Basis bzw. das Gate des Integrator-Transistors zwischengeschaltet ist,
- die Basis bzw. das Gate des Integrator-Transistors über den zweiten Integrator-Kondensator an ein vorzugsweise festes Potential, insbesondere an Masse, gelegt ist,
- ein Pol der Zusatzspannungsquelle über die Kollektor-Emitter-Strecke bzw. die Drain-Source-Strecke des Integrator-Transistors und den ersten Vorwiderstand an die Basis bzw. das Gate des Steuertransistors angelegt ist,
- der andere Pol der Zusatzspannungsquelle an Masse gelegt ist,
- und die Kollektor-Emitter-Strecke bzw. die Drain-Source-Strecke des Integrator-Transistors in Durchlassrichtung des durch die Zusatzspannungsquelle in Gang gesetzten Stromes geschaltet ist.

Gemäß einer weiteren Ausführungsform umfaßt der Integrator folgende Bauteile:

- einen Integrator-Transistor,
- einen dritten, vierten und einen fünften Integrator-Widerstand,
- einen zweiten Vorwiderstand,
- einen dritten Integrator-Kondensator sowie
- eine externe Zusatzspannungsquelle

wobei

- der dritte Integrator-Widerstand zwischen den Ansteuerausgang und die Basis bzw. das Gate des Integrator-Transistors zwischengeschaltet ist,
- die Basis bzw. das Gate des Integrator-Transistors über den vierten Integrator-Widerstand an Masse oder ein anderes vorzugsweise festes Potential gelegt ist,
- der Kollektor bzw. der Drain des Integrator-Transistors

  - über den fünften Integrator-Widerstand mit einem Pol der Zusatzspannungsquelle,
  - über den dritten Integrator-Kondensator mit der Basis bzw. dem Gate des Integrator-Transistors, sowie
  - über den zweiten Vorwiderstand mit der Basis bzw. dem Drain des Steuertransistors

  verbunden ist,
- der andere Pol der Zusatzspannungsquelle an Masse gelegt ist,
- der Emitter bzw der Source-Anschluss des Integrator-Transistors an Masse oder ein anderes festes Potential gelegt ist, und
- die Kollektor-Emitter-Strecke bzw. die Drain-Source-Strecke des Integrator-Transistors in Durchlassrichtung des durch die Zusatzspannungsquelle in Gang gesetzten Stromes geschaltet ist.

Gemäß einer vorteilhaften Ausführungsform der Erfindung weist die Ansteuerschaltung einen mit dem Ausgang der Kippschaltung bzw. des Schmitt-Triggers verbundenen Eingang auf und ist imstande, die Frequenz des Oszillators über den Eingang zu erfassen und mittels des Ansteuersignals so zu beeinflussen, dass die Frequenz des Oszillators sinkt, falls sie größer ist als eine vorgebbare Sollfrequenz, und steigt, falls sie kleiner ist als die Sollfrequenz, so dass der Oszillator ein geregelter Oszillator ist. Die Ansteuerschaltung ist daher bevorzugt zugleich als Frequenzmesseinrichtung ausgebildet. Sie kann hierzu z.B. einen Frequenzzähler enthalten oder als EDV-Einrichtung, insbesondere Mikrocontroller, ausgebildet sein, welche als Frequenzmesseinrichtung zu fungieren imstande ist.

Eine Variante des Verfahrens ist dadurch gekennzeichnet, dass als Ansteuerschaltung eine solche verwendet wird, welche einen mit dem Ausgang der Kippschaltung bzw. des Schmitt-Triggers verbundenen Eingang aufweist, über welchen die Frequenz des Oszillators erfasst wird, wobei die Frequenz des Oszillators mittels des Ansteuersignals so beeinflusst wird, dass sie sinkt, falls sie größer ist als eine vorgebbare Sollfrequenz, und steigt, falls sie kleiner ist als die Sollfrequenz, so dass die Frequenz des Oszillators über die Ansteuerschaltung geregelt wird.

Die Oszillatorfrequenz wird gemäß dieser bevorzugten Variante mit der Sollfrequenz verglichen und das Ansteuersignal dementsprechend eingestellt, d.h. das Ansteuersignal ist abhängig vom Ergebnis dieses Vergleichs: Falls die Oszillatorfrequenz größer ist als die Sollfrequenz, wird das Ansteuersignal so eingestellt, dass die Oszillatorfrequenz abnimmt; falls die Oszillatorfrequenz kleiner ist als die Sollfrequenz, wird das Ansteuersignal so eingestellt, dass die Oszillatorfrequenz zunimmt. Somit ist der Oszillator ein geregelter Oszillator.

Hierbei sind verschiedene Fälle möglich:

(i) Falls der Integrator ein nicht-invertierender Integrator ist und der Oszillator ein solcher ist, dessen Frequenz mit steigender Steuerspannung zunimmt, wird über den Ansteuerausgang als Ansteuersignal eine Spannung, welche gleich oder kleiner ist als der erste Spannungswert, auf den Integrator aufgegeben und somit die Frequenz des Oszillators verringert, wenn diese größer ist als eine vorgebbare Sollfrequenz, und andernfalls als Ansteuersignal eine Spannung, welche gleich oder größer ist als der zweite Spannungswert, auf den Integrator aufgegeben und somit die Frequenz des Oszillators erhöht.

(ii) Falls der Integrator ein nicht-invertierender Integrator ist und der Oszillator ein solcher ist, dessen Frequenz mit steigender Steuerspannung abnimmt, wird über den Ansteuerausgang als Ansteuersignal eine Spannung, welche gleich oder kleiner ist als der erste Spannungswert, auf den Integrator aufgegeben und somit die Frequenz des Oszillators erhöht, wenn diese kleiner ist als eine vorgebbare Sollfrequenz, und andernfalls als Ansteuersignal eine Spannung, welche gleich oder größer ist als der zweite Spannungswert, auf den Integrator aufgegeben und somit die Frequenz des Oszillators verringert.

(iii) Falls der Integrator ein invertierender Integrator ist und der Oszillator ein solcher ist, dessen Frequenz mit steigender Steuerspannung zunimmt, wird über den Ansteuerausgang als Ansteuersignal eine Spannung, welche gleich oder kleiner ist als der erste Spannungswert, auf den Integrator aufgegeben und somit die Frequenz des Oszillators erhöht, wenn diese kleiner ist als eine vorgebbare Sollfrequenz, und andernfalls als Ansteuersignal eine Spannung, welche gleich oder größer ist als der zweite Spannungswert, auf den Integrator aufgegeben und somit die Frequenz des Oszillators verringert.

(iv) Falls der Integrator ein invertierender Integrator ist und der Oszillator ein solcher ist, dessen Frequenz mit steigender Steuerspannung abnimmt, wird über den Ansteuerausgang als Ansteuersignal eine Spannung, welche gleich oder kleiner ist als der erste Spannungswert, auf den Integrator aufgegeben und somit die Frequenz des Oszillators verringert, wenn diese größer ist als eine vorgebbare Sollfrequenz, und andernfalls als Ansteuersignal eine Spannung, welche gleich oder größer ist als der zweite Spannungswert, auf den Integrator aufgegeben und somit die Frequenz des Oszillators erhöht.

Die Ansteuerschaltung erhält somit die Frequenz des Oszillators als Eingangsgröße, und der Oszillator wird über die Ansteuerschaltung geregelt.

Die Frequenz des Oszillators kann insbesondere in Zeitabständen oder intervallweise erfasst werden. Ebenso können die Veränderungen der Frequenz des Oszillators in Zeitabständen erfolgen, z.B. stets nach einem Vergleich von dessen Frequenz mit der Sollfrequenz. Diese Veränderungen können z.B. jeweils stufenweise erfolgen.

Gemäß einer Ausführungsform der Oszillatorschaltung ist die Ansteuerschaltung imstande, die zeitliche Abfolge des ersten und des zweiten Spannungswertes so zu verändern, dass die Frequenz des Oszillators fällt, wenn die Frequenz des Oszillators größer ist als die vorgebbare Sollfrequenz, und die Frequenz des Oszillators steigt, wenn die Frequenz des Oszillators kleiner ist als die vorgebbare Sollfrequenz, so dass der Oszillator ein über eine Pulsmodulation geregelter Oszillator ist.

Vorzugsweise werden die Steuerungs- bzw. Regelungseingriffe, welche nach einem Vergleich der Frequenz des Oszillators mit der Sollfrequenz ausgeführt werden, z.B. eine Veränderung des Ansteuersignals, in Zeitabständen vorgenommen oder ausgelöst.

Vorzugsweise ist das Ansteuersignal ein solches, welches ausschließlich aus einer Abfolge des ersten und des zweiten Spannungswertes besteht, und ist somit vorzugsweise ein Binärsignal.

Die zeitliche Abfolge des ersten und des zweiten Spannungswertes kann so verändert werden, dass die Frequenz des Oszillators fällt, wenn die Frequenz des Oszillators größer ist als die vorgebbare Sollfrequenz, und die Frequenz des Oszillators steigt, wenn die Frequenz des Oszillators kleiner ist als die vorgebbare Sollfrequenz, so dass der Oszillator über eine Pulsmodulation geregelt wird.

Die Pulsmodulation kann insbesondere eine Pulsweitenmodulation sein. Vorteilhafterweise ist auf Grund der Pulsmodulation zwischen der Ansteuerschaltung und dem Integrator lediglich die Übertragung des Ansteuersignals erforderlich, d.h. der Oszillator wird vorzugsweise ausschließlich durch die zeitliche Abfolge zweier Spannungswerte gesteuert, wozu vorteilhafterweise eine einzige Leitung ausreichend und keinerlei Erkennung von Datenwörtern usw. erforderlich ist. Die Pulsmodulation gestattet daher die hochpräzise Steuerung oder Regelung der Oszillatorfrequenz mit sehr hoher Frequenzauflösung und dennoch einem extrem geringen Aufwand.

Gemäß einer Ausführungsform der erfindungsgemäßen Oszillatorschaltung weist die Ansteuerschaltung eine EDV-Einrichtung mit folgenden Komponenten auf:

- einen ersten Binäranschluss, welcher ein erstes Binärsignal abgibt und über eine erste Zuleitung, in welcher ein erster Zwischenwiderstand zwischengeschaltet ist, mit dem Ansteuerausgang verbunden ist,
- einen zweiten Binäranschluss, welcher ein zweites Binärsignal abgibt und über eine zweite Zuleitung, in welcher eine erste Diode und ein dieser in Serie nachgeschalteter zweiter Zwischenwiderstand zwischengeschaltet sind, mit dem Ansteuerausgang verbunden ist, wobei

  - der zweite Zwischenwiderstand einen kleineren Wert aufweist als der erste Zwischenwiderstand,
  - und die Anode der ersten Diode mit dem zweiten Binäranschluss und die Kathode der ersten Diode mit dem zweiten Zwischenwiderstand verbunden ist,

- einen dritten Binäranschluss, welcher ein drittes Binärsignal abgibt und mit einer dritten Zuleitung verbunden ist, welche zwischen der ersten Diode und dem zweiten Zwischenwiderstand von der zweiten Zuleitung abzweigt und in welcher eine zweite Diode zwischengeschaltet ist, deren Kathode mit dem dritten Binäranschluss und deren Anode mit der Kathode der ersten Diode verbunden ist,

wobei

a) das erste, zweite und dritte Binärsignal jeweils ein High-Signal oder ein Low-Signal oder eine zeitliche Abfolge von solchen ist,
b) der erste Binäranschluss ein High-Signal abgibt, falls die Frequenz des Oszillators kleiner ist als die Sollfrequenz, und andernfalls ein Low-Signal abgibt, oder umgekehrt, und
c) die Ansteuerschaltung

  - in einen ersten Modus, schneller Modus, versetzbar ist, in welchem der zweite und der dritte Binäranschluss

- jeweils dann ein High-Signal abgeben, wenn der erste Binäranschluss ein High-Signal abgibt,
- und jeweils dann ein Low-Signal abgeben, wenn der erste Binäranschluss ein Low-Signal abgibt,

so dass der Integrator das Ansteuersignal mit einer ersten Zeitkonstanten zu der Steuerspannung zu integrieren imstande ist,

- und in einen zweiten Modus, langsamer Modus, versetzbar ist, in welchem der zweite Binäranschluss stets ein Low-Signal und der dritte Binäranschluss stets ein High-Signal abgibt, so dass der Integrator das Ansteuersignal mit einer zweiten Zeitkonstanten, welche größer ist als die erste Zeitkonstante, zu der Steuerspannung zu integrieren imstande ist.

Gemäß einer vorteilhaften Variante des Verfahrens wird daher als Ansteuerschaltung eine solche verwendet, welche eine EDV-Einrichtung mit folgenden Komponenten aufweist:

- einen ersten Binäranschluss, welcher ein erstes Binärsignal abgibt und über eine erste Zuleitung, in welcher ein erster Zwischenwiderstand zwischengeschaltet ist, mit dem Ansteuerausgang verbunden ist,
- einen zweiten Binäranschluss, welcher ein zweites Binärsignal abgibt und über eine zweite Zuleitung, in welcher eine erste Diode und ein dieser in Serie nachgeschalteter zweiter Zwischenwiderstand zwischengeschaltet sind, mit dem Ansteuerausgang verbunden ist, wobei

  - der zweite Zwischenwiderstand einen kleineren Wert aufweist als der erste Zwischenwiderstand,
  - und die Anode der ersten Diode mit dem zweiten Binäranschluss und die Kathode der ersten Diode mit dem zweiten Zwischenwiderstand verbunden ist,

- einen dritten Binäranschluss, welcher ein drittes Binärsignal abgibt und mit einer dritten Zuleitung verbunden ist, welche zwischen der ersten Diode und dem zweiten Zwischenwiderstand von der zweiten Zuleitung abzweigt und in welcher eine zweite Diode zwischengeschaltet ist, deren Kathode mit dem dritten Binäranschluss und deren Anode mit der Kathode der ersten Diode verbunden ist,

wobei

a) das erste, zweite und dritte Binärsignal jeweils ein High-Signal oder ein Low-Signal oder eine zeitliche Abfolge von solchen ist,
b) der erste Binäranschluss ein High-Signal abgibt, falls die Frequenz des Oszillators kleiner ist als die Sollfrequenz, und andernfalls ein Low-Signal abgibt, oder umgekehrt, und
c) die Ansteuerschaltung

  - in einen ersten Modus, schneller Modus, versetzbar ist, in welchem der zweite und der dritte Binäranschluss

    - jeweils dann ein High-Signal abgeben, wenn der erste Binäranschluss ein High-Signal abgibt,
    - und jeweils dann ein Low-Signal abgeben, wenn der erste Binäranschluss ein Low-Signal abgibt,

    so dass der Integrator das Ansteuersignal mit einer ersten Zeitkonstanten zu der Steuerspannung zu integrieren imstande ist,
  - und in einen zweiten Modus, langsamer Modus, versetzbar ist, in welchem der zweite Binäranschluss stets ein Low-Signal und der dritte Binäranschluss stets ein High-Signal abgibt, so dass der Integrator das Ansteuersignal mit einer zweiten Zeitkonstanten, welche größer ist als die erste Zeitkonstante, zu der Steuerspannung zu integrieren imstande ist.

Die Ansteuerschaltung befindet sich somit im schnellen Modus, wenn das zweite und das dritte Binärsignal beide High-Signale oder beide Low-Signale sind, und im langsamen Modus, wenn das zweite Binärsignal ein Low-Signal und das dritte Binärsignal ein High-Signal ist. Die Zeitkonstante der Integration kann daher vorteilhafterweise per Software umgeschaltet werden.

Bevorzugt wird die Ansteuerschaltung nach einem Einschalten oder Reset derselben automatisch zunächst in den schnellen und

- nach einer bestimmten Zeitdauer
- oder dann, wenn die Frequenz des Oszillators einen vorgegebenen Abstand von der Sollfrequenz unterschritten hat,
- oder dann, wenn die Frequenz des Oszillators einen vorgegebenen Frequenzbereich erreicht hat,

in den langsamen Modus versetzt.

Gemäß einer bevorzugten Ausführungsform der erfindungsgemäßen Oszillatorschaltung ist die Ansteuerschaltung imstande, nach einem Einschalten oder Reset derselben sich selbsttätig zunächst in den schnellen und

- nach einer bestimmten Zeitdauer
- oder dann, wenn die Frequenz des Oszillators einen vorgegebenen Abstand von der Sollfrequenz unterschritten hat,
- oder dann, wenn die Frequenz des Oszillators einen vorgegebenen Frequenzbereich erreicht hat,

in den langsamen Modus zu versetzen.

Gemäß einer Ausführungsform ist der Integrator entweder ein nicht-invertierender Integrator, der zusätzlich einen invertierenden Integratoreingang aufweist, an welchen eine Referenzspannung angelegt ist, oder ein invertierender Integrator, welcher zusätzlich einen nicht-invertierenden Integratoreingang aufweist, an welchen eine Referenzspannung angelegt ist.

Gemäß einer Variante des Verfahrens wird daher als Integrator entweder ein nicht-invertierender Integrator verwendet, welcher zusätzlich einen invertierenden Integratoreingang aufweist, an welchen eine Referenzspannung angelegt wird, oder ein invertierender Integrator verwendet, welcher zusätzlich einen nicht-invertierenden Integratoreingang aufweist, an welchen eine Referenzspannung angelegt wird.

Gemäß einer Variante wird eine solche Referenzspannung an den zusätzlichen Integratoreingang angelegt, welche gleich dem arithmetischen Mittel aus dem ersten und dem zweiten Spannungswert ist. Die Referenzspannung kann somit insbesondere gleich dem arithmetischen Mittel aus dem ersten und dem zweiten Spannungswert sein.

Die Referenzspannung kann dazu dienen, das zeitliche Verhalten des Integrators bei Anliegen des ersten Spannungswertes gegenüber seinem zeitlichen Verhalten bei Anliegen des zweiten Spannungswertes zu symmetrieren.

Als Sollfrequenz kann die Frequenz einer Wechselspannung, insbesondere die Ausschwingfrequenz eines Ultraschallwandlers, verwendet werden. A18 Gemäß einer Ausführungsform der Erfindung weist die Ansteuerschaltung daher einen weiteren Eingang auf und ist imstande, über diesen die Frequenz einer Wechselspannung, insbesondere die Ausschwingfrequenz eines Ultraschallwandlers, zu erfassen und als Sollfrequenz heranzuziehen.

Im folgenden werden unter Bezugnahme auf die Figuren bevorzugte Ausführungsformen der Erfindung erläutert.

Kurzbeschreibung der Zeichnung, in welcher schematisch zeigen:

Fig. 1        eine erfindungsgemäße Oszillatorschaltung mit einem variablen Widerstand Rvar gemäß einer Ausführungsform der Erfindung,

Fig. 2        ein Blockschaltbild einer erfindungsgemäßen spannungs- bzw. stromgesteuerten Oszillatorschaltung mit einem Steuerwiderstand, an welchen gemäß einer bevorzugten Ausführungsform der Erfindung ein Integrator angeschlossen ist,

Fig. 3-5      verschiedene Ausführungsformen von Integratoren und Steuerwiderständen, welche in der Schaltung von Fig. 2 als Integrator bzw. als Steuerwiderstand verwendet werden können,

Fig. 6        die Oszillatorschaltung von Fig. 2 zusammen mit einer Ansteuerschaltung, welche im Beispiel von Fig. 6 eine EDV-Einrichtung ist,

Fig. 7        eine erfindungsgemäße Oszillatorschaltung mit einer Ansteuerschaltung, einem Oszillator sowie einem Integrator,

Fig. 8        ein Beispiel für das Ausregeln einer Frequenzabweichung durch die Oszillatorschaltung von Fig. 7,

Fig. 9        eine Ausführungsform des variablen Widerstandes Rvar von Fig. 1 mit einem daran angeschlossenen Integrator,

Fig. 10      eine Ausführungsform des variablen Widerstandes Rvar von Fig. 1 mit einem anderen daran angeschlossenen Integrator,

Fig. 11      eine Ausführungsform des variablen Widerstandes Rvar von Fig. 1 mit einem nochmals anderen daran angeschlossenen Integrator,

Fig. 12      eine Ansteuerschaltung, welche eine Beeinflussung der Integrationszeit z.B. des Integrators von Fig. 1 ermöglicht,

Fig. 13-20   verschiedene Ausführungsformen von Steuerwiderständen, welche in einem erfindungsgemäßen Oszillator jeweils als variabler Widerstand bzw. als Steuerwiderstand einsetzbar sind, und

Fig. 21      eine Tabelle.

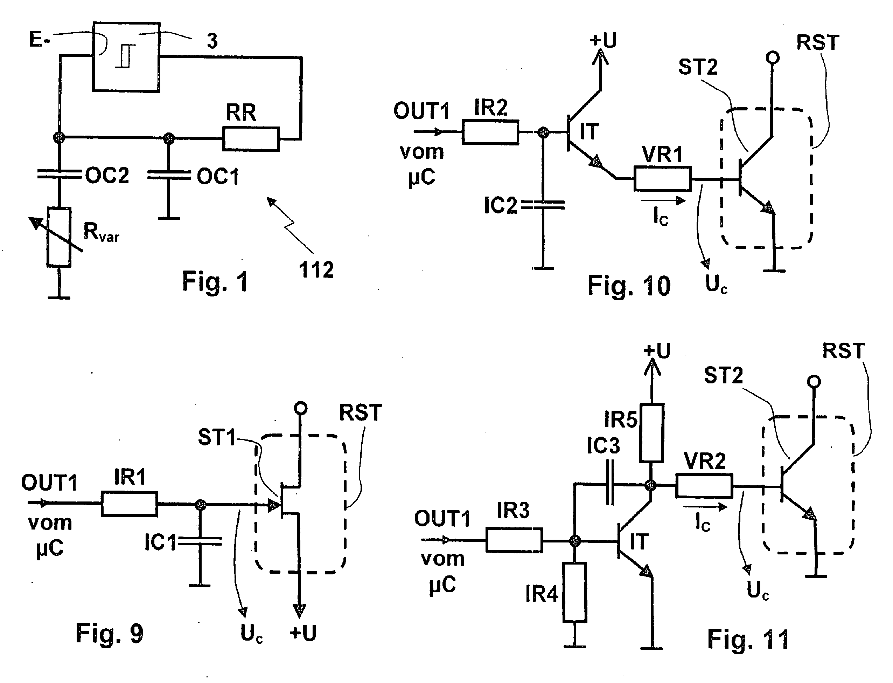

Fig. 1 zeigt eine Ausführungsform einer erfindungsgemäßen Oszillatorschaltung mit einem variablen Widerstand $R_{var}$ gemäß einer Ausführungsform der Erfindung. Die Oszillatorschaltung von Fig. 1 besteht aus einem Oszillator 112, welcher im folgenden auch als VCO bezeichnet wird und einen Schmitt-Trigger 3 mit einem Ausgang A und einem invertierenden Eingang E- umfasst. Der Ausgang A ist über einen Rückkopplungswiderstand RR mit dem invertierenden Eingang E-verbunden. Der invertierende Eingang E- ist über einen ersten Oszillator-Kondensator OC1 an Masse gelegt. Der invertierende Eingang E- ist ferner über einen zweiten Oszillator-Kondensator OC2 und einen mit diesem in Serie geschalteten Steuerwiderstand $R_{var}$, dessen Wert einstellbar oder elektrisch steuerbar ist, an Masse gelegt. Daher ist die Frequenz f des Oszillators 112 durch Verändern des Wertes des Steuerwiderstandes $R_{var}$ veränderbar: bei Verringerung des Wertes von $R_{var}$ fällt die Frequenz f, bei Erhöhung des Wertes von $R_{var}$ steigt die Frequenz f.

Gemäß einer bevorzugten Variante, welche in Fig. 1 veranschaulicht ist, wird das Prinzip Schmitt-Trigger/ Integrator verwendet, wobei aber durch die spezielle schaltungstechnische Lösung der veränderbare oder einstellbare, bevorzugt steuerbare Widerstand $R_{var}$ gegen ein vorzugsweise festes Bezugspotential, z.B. Masse, arbeitet und deshalb leicht anzusteuern ist.

Merkmale des erfindungsgemäßen VCO nach Fig. 1 sind:

- Teilung der frequenzbestimmenden Kapazität C in vorzugsweise zwei Teilkapazitäten OC1 und OC 2.
- Ein Teil der frequenzbestimmenden Kapazität ist mit einem steuerbaren Widerstand $R_{var}$ in Reihe geschaltet.
- $R_{var}$ ist auf ein festes Potential bezogen.

Dabei sind auch andere Oszillatorgrundschaltungen (z.B. LC-Oszillatoren, Phasenschieber-Oszillatoren) einsetzbar.

Der erfindungsgemäße spannungs- bzw. stromgesteuerte Oszillator von Fig. 1 besteht aus einem über das Integrationsglied RR, OC1 II (OC2 + $R_{var}$) rückgekoppelten invertierenden Schmitt-Trigger 3 (z.B. Schmitt-Trigger-Inverter aus diversen Logik-Familien oder Timer-IC x555). Der Ausdruck RR,OC1 II (OC2+$R_{var}$) bedeutet hierbei, dass das genannte Integrationsglied den Widerstand RR und den Kondensator OC1 sowie eine zu diesem parallel geschaltete Serienschaltung aus dem Kondensator OC2 und dem veränderlichen Widerstand $R_{var}$ umfaßt. Der invertierende Schmitt-Trigger 3 ist über den Widerstand RR rückgekoppelt, wobei der Eingang des invertierenden Schmitt-Triggers 3 sowohl über OC1 als auch über die Serienschaltung aus OC2 und $R_{var}$ an Masse gelegt ist.

Der Ladestrom von OC1 II (OC2 + $R_{var}$) erzeugt über RR einen Spannungsabfall, so dass nach dem Kippen des Triggerausgangs die jeweils andere Triggerschwelle entsprechend verzögert erreicht wird.

Der Ausdruck OC1 II (OC2+$R_{var}$) bedeutet hierbei, dass der Kondensator OC1 mit der Serienschaltung aus dem Kondensator OC2 und dem veränderlichen Widerstand $R_{var}$ parallel geschaltet ist. Diese Verzögerungszeit bestimmt die Frequenz der astabilen Kippschaltung. $R_{var}$ ist im Idealfall von R=0 (daraus folgt: OC1 II OC2, d.h. OC1 ist zu OC2 parallelgeschaltet) bis R→∞ (OC2 ist dann unwirksam) stufenlos einstellbar. Entsprechend dem Wert von $R_{var}$ fließt durch OC2 ein Strom, welcher sich zu dem Strom durch OC1 addiert und somit zusammen mit diesem die Verzögerungszeit bestimmt.

Damit ist durch Verstellen des Wertes von $R_{var}$ die Frequenz der Kippschaltung in einem durch das Verhältnis von OC1 zu OC2 und den Widerstandsstellbereich von $R_{var}$ bestimmten Bereich stufenlos einstellbar.

Als elektronisch steuerbare Widerstände $R_{var}$ sind z.B. JFET und Bipolartransistoren geeignet.

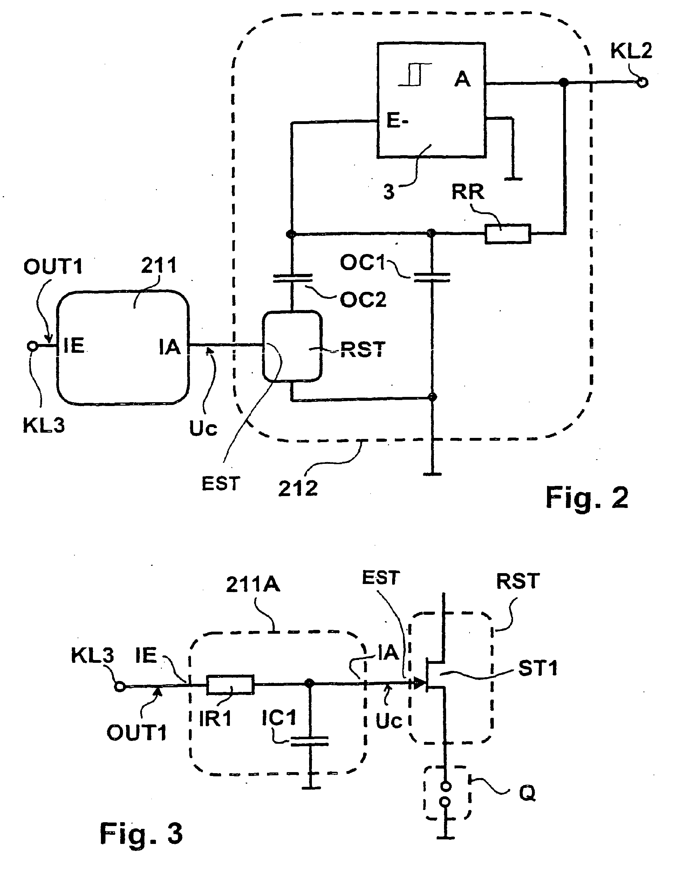

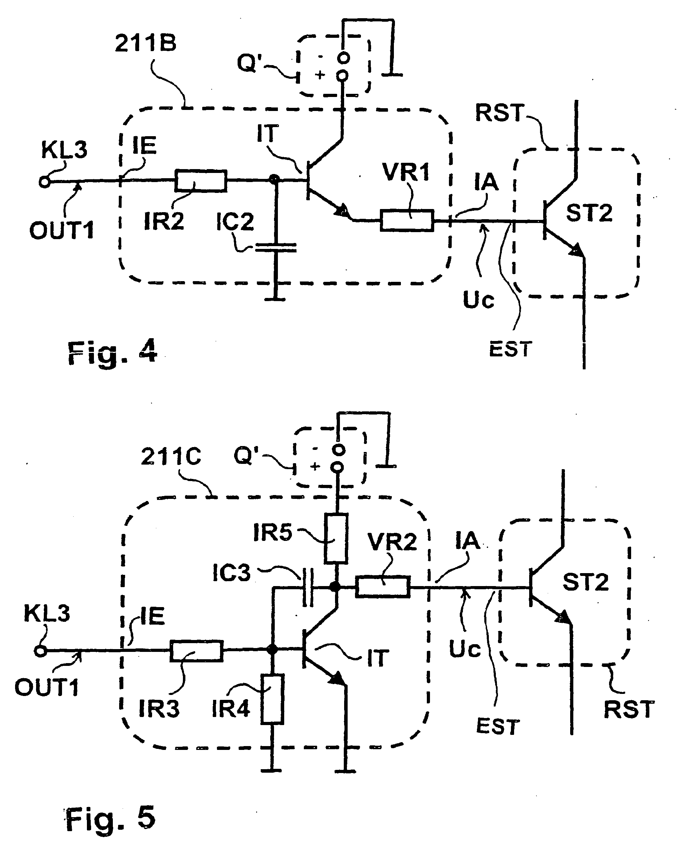

Fig. 2 zeigt schematisch ein Blockschaltbild einer anderen Ausführungsform einer erfindungsgemäßen Oszillatorschaltung, mit einem Oszillator 212, an welchen gemäß einer bevorzugten Ausführungsform der Erfindung ein Integrator 211 angeschlossen ist, dessen Funktion unten erläutert wird. Der Integrator 211 kann in verschiedenen Ausführungsformen realisiert sein; die Integratoren 211A (Fig. 3), 211 B (Fig. 4) und 211C (Fig. 5) sind Beispiele für Ausführungsformen des Integrators 211.

Der Oszillator 212 umfaßt eine Kippstufe oder einen Verstärker mit HystereseVerhalten oder einen Relaxationsoszillator, im Beispiel von Fig. 2 ausgebildet als Schmitt-Trigger 3, mit einem Ausgang A und einem invertierenden Eingang E-. Der Ausgang A des Schmitt-Triggers 3 ist über den Rückkopplungswiderstand RR mit dem invertierenden Eingang E- verbunden. Der invertierende Eingang E- ist über den ersten Oszillator-Kondensator OC1 an Masse gelegt und ferner über den zweiten Oszillator-Kondensator OC2 und einen Steuerwiderstand RST, dessen Wert einstellbar oder elektrisch steuerbar ist, mit Masse verbunden. An die Stelle der Masse bzw. des Massepotentials kann generell ein anderes, vorzugsweise festes Potential als Bezugspotential treten.

Die Frequenz des Oszillators 212 ist durch Vergrößern des Wertes des Steuerwiderstandes RST erhöhbar und durch Verkleinern des Wertes des Steuerwiderstandes RST verringerbar.

Der Steuerwiderstand kann z.B. ein einstellbarer Widerstand - Trimmer - oder z.B. ein Fotowiderstand sein; diese Fälle entsprechen nicht der Oszillatorschaltung von Fig. 2, da der Steuerwiderstand RST von Fig. 2 ein elektrisch steuerbarer Widerstand mit einem Steuereingang EST ist. Der Wert des Steuerwiderstands RST von Fig. 2 ist durch Anlegen einer Steuerspannung Uc an den Steuereingang EST steuerbar. Somit ist auch die Frequenz des Oszillators 212 elektrisch steuerbar.

Die Steuerspannung Uc kann im Prinzip von jeder Spannungsquelle oder Stromquelle geliefert werden. Im Ausführungsbeispiel von Fig. 2 dient zur Erzeugung der Steuerspannung Uc der Integrator 211, welcher in Fig. 2 ebenso wie der Steuerwiderstand RST nicht detailliert, sondern nur in Form eines Platzhalters dargestellt ist. Die Figuren 3 bis 5 und 13 bis 20 zeigen verschiedene Ausführungsformen von Integratoren 211A, 211B, 211C und Steuerwiderständen ST1, ST2, ST3, ST4, welche in der Schaltung von Fig. 2 als Integrator 211 bzw. als Steuerwiderstand RST verwendet werden können.

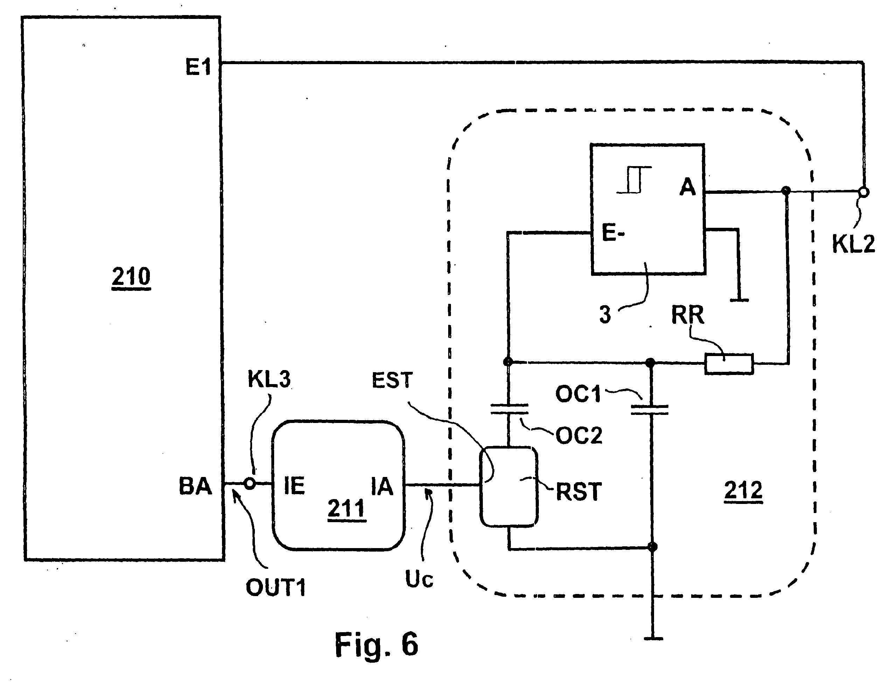

Der Integrator 211 besitzt einen z.B. nicht-invertierenden Eingang IE, welcher z.B. gemäß einer bevorzugten Ausführungsform der Erfindung über eine Klemme KL3 mit dem Ansteuerausgang BA einer in Fig. 2 bis Fig. 5 nicht gezeigten Ansteuerschaltung 210 (Fig. 6) verbunden ist. Diese ist imstande, über den Ansteuerausgang BA an den Eingang IE des Integrators 211 ein Ansteuersignal OUT1 abzugeben, welches entweder gleich einem ersten oder einem zweiten Spannungswert U1,U2 ist und somit aus einer zeitlichen Abfolge dieser Spannungswerte U1,U2 besteht, wobei der erste Spannungswert U1 kleiner ist als der zweite Spannungswert U2. Der Integrator 211 integriert das Ansteuersignal OUT1 zu der Steuerspannung Uc und gibt diese über den Ausgang IA an den Steuereingang EST des Steuerwiderstandes RST, d.h. z.B. an die Basis bzw. das Gate des Steuertransistors ST1 ab. Der Integrator 211 wird also mit dem Ansteuersignal OUT1 angesteuert und liefert die Steuerspannung Uc.

Aufgrund der Integration des Ansteuersignals OUT1 durch den Integrator 211 nimmt die Steuerspannung Uc dann ab, wenn das Ansteuersignal OUT1 gleich dem ersten Spannungswert U1 ist, und nimmt die Steuerspannung Uc dann zu, wenn das Ansteuersignal OUT1 gleich dem zweiten Spannungswert U2 ist. oder umgekehrt. In beiden Fällen ändert sich aufgrund der Änderung des Wertes des Steuerwiderstandes RST die Frequenz f des Oszillators 212. Beispielsweise kann der Steuerwiderstand so ausgebildet sein, dass er dann hochohmiger wird, wenn die Steuerspannung Uc sinkt, und dann niederohmiger wird, wenn die Steuerspannung Uc steigt, oder umgekehrt.

Die Steuerspannung Uc hängt somit von der zeitlichen Abfolge des ersten und des zweiten Spannungswertes U1,U2 im Ansteuersignal OUT1 ab, d.h. die Frequenz des Oszillators 212 läßt sich vorteilhafterweise durch diese zeitliche Abfolge steuern.

Der Steuerwiderstand RST kann, anstatt direkt mit Masse verbunden zu sein, über eine in Fig. 2 nicht gezeigte zwischengeschaltete Spannungsquelle Q mit Masse verbunden sein (vgl. z.B. Fig. 3).

Der Integrator kann zusätzlich einen invertierenden Eingang aufweisen (in Fig. 2 - 5 nicht gezeigt), an welchen eine Referenzspannung Uo angelegt ist, welche vorzugsweise gleich dem arithmetischen Mittel aus dem ersten und dem zweiten Spannungswert U1,U2 ist. Die Referenzspannung Uo kann insbesondere dazu dienen, das zeitliche Verhalten des Integrators bei Anliegen des ersten Spannungswertes U1 gegenüber seinem zeitlichen Verhalten bei Anliegen des zweiten Spannungswertes U2 zu symmetrieren.

Der Steuerwiderstand RST kann z.B. durch die Kollektor-Emitter-Strecke bzw. der Drain-Source-Strecke eines Transistors ST1, der im folgenden als Steuertransistor bezeichnet wird, gebildet sein (Fig. 3), so dass der zweite Oszillator-Kondensator OC2 über die Kollektor-Emitter-Strecke bzw. die Drain-Source-Strecke des Steuertransistors ST1 an Masse gelegt ist, wobei der Steuerwiderstand ST1 im Beispiel von Fig. 3 in Abweichung von Fig. 2 nicht direkt, sondern über eine zwischengeschaltete Spannungsquelle Q mit Masse verbunden ist.

Wenn der Steuerwiderstand RST durch die Kollektor-Emitter-Strecke eines bipolaren Transistors gebildet ist, dann fungiert dessen Basis als Steuereingang EST. Wenn der Steuerwiderstand RST durch die Drain-Source-Strecke eines Feldeffekt-Transistors gebildet ist, dann fungiert dessen Gate als Steuereingang EST. Die Frequenz des Oszillators 212 ist in der Schaltung von Fig. 3 durch Vergrößern der an der Basis bzw. des Gates des Steuertransistors ST1 anliegenden Steuerspannung Uc verringerbar und durch Verkleinern der an der Basis bzw. des Gates des Steuertransistors ST1 anliegenden Steuerspannung Uc erhöhbar.

Die Basis bzw. das Gate des Steuertransistors ST1 von Fig. 3 ist mit dem Ausgang IA des Integrators 211 verbunden.

Der Integrator 211A von Fig. 3, welcher ein Beispiel für eine Ausführungsform des Integrators 211 von Fig. 2 ist, besteht lediglich aus einem ersten Integrator-Wderstand IR1, welcher zwischen den Integrator-Eingang IE und die Basis bzw. das Gate des Steuertransistors ST1 zwischengeschaltet ist, und aus einem ersten Integrator-Kondensator IC1, über welchen die Basis bzw. das Gate des Steuertransistors ST1 an Masse gelegt ist. D.h. der Integrator 211A von Fig. 3 ist ein einfacher RC-Tiefpaß.

Fig. 4 zeigt einen Integrator 211 B, welcher ein weiteres Beispiel für eine Ausführungsform des Integrators 211 von Fig. 2 ist. Der Integrator 211B von Fig. 4 umfaßt folgende Bauteile: einen Integrator-Transistor IT, einen zweiten Integrator-Widerstand IR2, einen ersten Vorwiderstand VR1, einen zweiten Integrator-Kondensator IC2 sowie eine externe Zusatzspannungsquelle Q'. Der Steuerwiderstand RST ist als Steuer-Transistor ST2 ausgebildet.

Der zweite Integrator-Widerstand IR2 ist zwischen den Integrator-Eingang IE und die Basis bzw. das Gate des Integrator-Transistors IT zwischengeschaltet. Die Basis bzw. das Gate des Integrator-Transistors IT ist über den zweiten Integrator-Kondensator IC2 an Masse gelegt, d.h. dem Integrator-Transistor IT ist ein RC-Tiefpaß IR2, IC2 vorgeschaltet. Ein Pol der Zusatzspannungsquelle Q' ist über die Kollektor-Emitter-Strecke bzw. die Drain-Source-Strecke des Integrator-Transistors IT und den ersten Vorwiderstand VR1 an die Basis bzw. das Gate des Steuertransistors ST2 angelegt. Der andere Pol der Zusatzspannungsquelle Q' ist an Masse gelegt. Die Kollektor-Emitter-Strecke bzw. die Drain-Source-Strecke des Integrator-Transistors IT ist hierbei in Durchlaßrichtung des durch die Zusatzspannungsquelle Q' in Gang gesetzten Stromes geschaltet.

Fig. 5 zeigt einen Integrator 211C, welcher ein weiteres Beispiel für eine Ausführungsform des Integrators 211 von Fig. 2 ist. Der Integrator 211C von Fig. 5 umfaßt folgende Bauteile: den Integrator-Transistor IT von Fig. 4, einen dritten, einen vierten und einen fünften Integrator-Widerstand IR3,IR4, IR5, einen zweiten Vorwiderstand VR2, einen dritten Integrator-Kondensator IC3 sowie die externe Zusatzspannungsquelle Q'. Der Steuerwiderstand RST ist als Steuer-Transistor ST2 ausgebildet.

Der dritte Integrator-Widerstand IR3 ist zwischen den Integrator-Eingang IE und die Basis bzw. das Gate des Integrator-Transistors IT zwischengeschaltet. Diese ist über den vierten Integrator-Widerstand IR4 an Masse (oder ein anderes festes Potential) gelegt. Der Kollektor bzw. der Drain des Integrator-Transistors IT ist über den fünften Integrator-Widerstand IR5 mit einem Pol der Zusatzspannungsquelle Q', ferner über den dritten Integrator-Kondensator IC3 mit der Basis bzw. dem Gate des Integrator-Transistors IT, sowie schließlich über den zweiten Vorwiderstand VR2 mit der Basis bzw. dem Drain des Steuertransistors ST2 verbunden. Der dritte Integrator-Kondensator IC3 bewirkt eine mit der Frequenz zunehmende Gegenkopplung des Integrator-Transistors IT und somit einen aktiven Tiefpaß. Der andere Pol der Zusatzspannungsquelle Q' ist an Masse gelegt. Der Emitter bzw. der Source-Anschluss des Integrator-Transistors IT ist an Masse (oder ein anderes festes Potential) gelegt.

Die Kollektor-Emitter-Strecke bzw. die Drain-Source-Strecke des Integrator-Transistors IT ist in Durchlaßrichtung des durch die Zusatzspannungsquelle Q' in Gang gesetzten Stromes geschaltet.

Der Steuerwiderstand RST bzw. die Steuertransistoren ST1 bzw. ST2 können, anstatt direkt mit Masse verbunden zu sein, über eine in den Fig. 2, 4 und 5 nicht gezeigte zwischengeschaltete Spannungsquelle Q mit Masse verbunden sein.

Gemäß einer Abwandlung der Schaltung von Fig. 3 sind Drain und Source des Steuertransistors ST1 gegenüber der Schaltung von Fig. 3 miteinander vertauscht, so dass der Steuertransistor ST1 invers betrieben wird.

Gemäß einer weiteren Abwandlung der Schaltung von Fig. 3 sind Gate und Source des Steuertransistors ST1 gegenüber der Schaltung von Fig. 3 miteinander vertauscht, so dass der Steuertransistor ST1 in Gate-Schaltung betrieben wird.

Gemäß einer Abwandlung der Schaltung von Fig. 4 oder Fig. 5 sind Kollektor und Emitter des Steuertransistors ST2 gegenüber der Schaltung von Fig. 4 bzw. Fig. 5 miteinander vertauscht, so dass der Steuertransistor ST2 invers betrieben wird.

Gemäß einer weiteren Abwandlung der Schaltung von Fig. 4 oder Fig. 5 sind Basis und Emitter des Steuertransistors ST1 gegenüber der Schaltung von Fig. 4 bzw. Fig. 5 miteinander vertauscht, so dass der Steuertransistor ST1 in Basisschaltung betrieben wird.

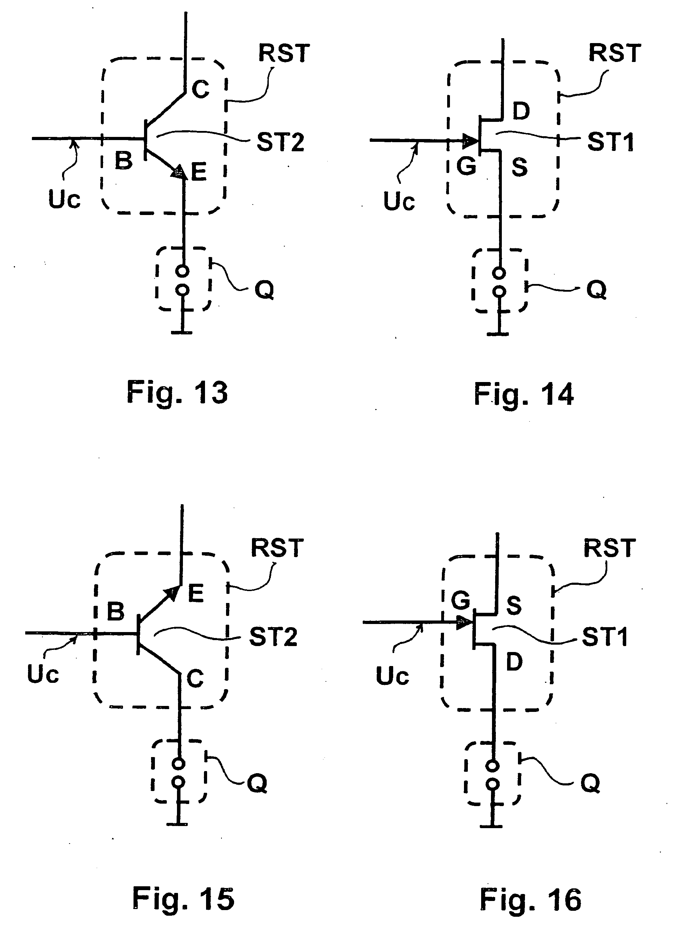

Die Figuren 13 bis 20 veranschaulichen verschiedene Ausführungsformen von Steuerwiderständen RST, welche in einem erfindungsgemäßen Oszillator 112,212 jeweils als variabler Widerstand Rvar bzw. als Steuerwiderstand RST einsetzbar sind. In den Figuren 13 bis 20 ist der jeweils nach oben aus dem Steuerwiderstand RST herausführend Anschluss mit dem zweiten Oszillator-Kondensator OC2 verbunden; an den nach links herausführenden Anschluss ist jeweils die Steuerspannung Uc angelegt.

Figur 13 zeigt einen Transistor ST2, dessen Kollektor C mit dem zweiten Oszillator-Kondensator OC2 verbunden ist und dessen Basis B mit der Steuerspannung Uc beaufschlagt ist. Der Emitter E ist bevorzugt direkt oder über die Spannungsquelle Q an Masse gelegt.

Figur 14 zeigt einen Steuer-FET ST1, dessen Drain-Anschluss D mit dem zweiten Oszillator-Kondensator OC2 verbunden ist und dessen Gate-Anschluss G mit der Steuerspannung Uc beaufschlagt ist. Der Source-Anschluss S ist bevorzugt direkt oder über die Spannungsquelle Q an Masse gelegt.

Die Schaltung von Figur 15 unterscheidet sich von der Schaltung von Figur 13 dadurch, dass in Figur 15 der Steuertransistor ST2 invers angeschlossen ist: der Emitter E ist mit dem zweiten Oszillator-Kondensator OC2 verbunden und der Kollektor C ist bevorzugt direkt oder über die Spannungsquelle Q an Masse gelegt.

Die Schaltung von Figur 16 unterscheidet sich von der Schaltung von Figur 14 dadurch, dass in Figur 16 der Steuer-FET ST1 invers angeschlossen ist: der Source-Anschluss ist mit dem zweiten Oszillator-Kondensator OC2 verbunden und der Drain-Anschluss D ist bevorzugt direkt oder über die Spannungsquelle Q an Masse gelegt.

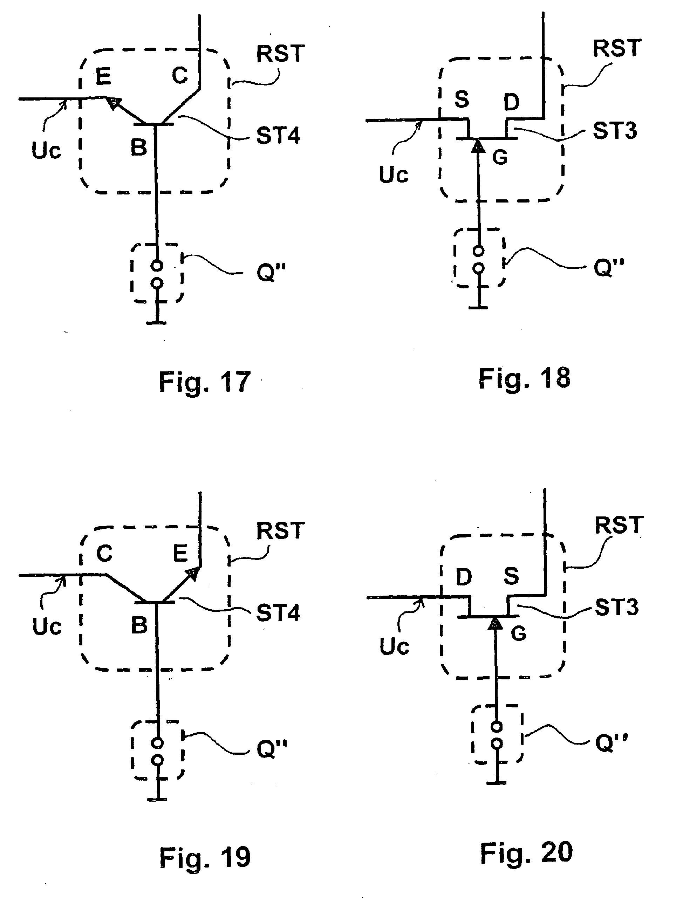

Figur 17 zeigt einen Transistor ST4 in Basisschaltung, dessen Kollektor C mit dem zweiten Oszillator-Kondensator OC2 verbunden ist und dessen Emitter E mit der Steuerspannung Uc beaufschlagt ist. Die Basis B ist an eine Spannungsquelle Q" gelegt.

Figur 18 zeigt einen Steuer-FET ST3 in Gate-Schaltung, dessen Drain-Anschluss D mit dem zweiten Oszillator-Kondensator OC2 verbunden ist und dessen Source-Anschluss mit der Steuerspannung Uc beaufschlagt ist. Der Gate-Anschluss G ist an eine Spannungsquelle Q" gelegt.

In Figur 19 ist der Steuertransistor ST4 ebenfalls in Basisschaltung, aber gegenüber Figur 17 invers angeschlossen: der Emitter E ist mit dem zweiten Oszillator-Kondensator OC2 verbunden und der Kollektor C ist mit der Steuerspannung beaufschlagt. Die Basis B ist an die Spannungsquelle Q" gelegt.

In Figur 20 ist der Steuer-FET ST3 ebenfalls in Gate-Schaltung, aber gegenüber Figur 19 invers angeschlossen: der Source-Anschluss S ist mit dem zweiten Oszillator-Kondensator OC2 verbunden und der Drain-Anschluss D ist mit der Steuerspannung beaufschlagt. Der Gate-Anschluss G ist an die Spannungsquelle Q" gelegt.

Fig. 6 zeigt als weiteres Beispiel einer erfindungsgemäßen Oszillatorschaltung den Oszillator 212 und den Integrator 211 von Fig. 2 zusammen mit der bereits oben unter Bezug auf Fig. 2 erwähnten, aber dort nicht dargestellten Ansteuerschaltung 210, welche im Beispiel von Fig. 6 eine EDV-Einrichtung, z.B. ein Mikrocontroller 210 ist. Diese weist einen mit dem Ausgang A des Schmitt-Triggers 3 verbundenen Eingang E1 auf und ist imstande, über den Eingang E1 die VCO-Frequenz, d.h. Frequenz des Oszillators 212, kontinuierlich oder in vorgebbaren Zeitabständen zu erfassen und mit einer vorgebbaren Sollfrequenz $f_{soll}$ zu vergleichen, und über den Ansteuerausgang BA das Ansteuersignal OUT1, bestehend aus einer zeitlichen Abfolge der Spannungswerte U1,U2, abzugeben und hiermit den Integrator 211 so anzusteuern, dass die VCO-Frequenz abnimmt, falls sie größer ist als die Sollfrequenz, und zunimmt, falls sie kleiner ist als die Sollfrequenz, so dass der Oszillator 212 im Beispiel von Fig. 6 geregelt wird.

D.h., falls die VCO-Frequenz größer ist als die Sollfrequenz $f_{soll}$, wird das Ansteuersignal OUT1 durch die Ansteuerschaltung 210 so eingestellt, dass die VCO-Frequenz abnimmt, und falls die VCO-Frequenz kleiner ist als die Sollfrequenz $f_{soll}$, wird das Ansteuersignal OUT1 durch die Ansteuerschaltung 210 so eingestellt, dass die VCO-Frequenz zunimmt.

Das Ansteuersignal OUT1 und damit die VCO-Frequenz werden hierbei gemäß einer Variante dadurch verändert, dass in Abhängigkeit von der Abweichung zwischen VCO-Frequenz und Sollfrequenz entweder der erste oder der zweite Spannungswert U1,U2 auf den Integrator-Eingang IE des Integrators 211 aufgegeben werden.

Gemäß einer anderen Variante werden die Steuerspannung (Uc), somit der Wert des Steuerwiderstandes RST und damit auch die Frequenz f des Oszillators 212 in Abhängigkeit von der Abweichung zwischen VCO-Frequenz und Sollfrequenz über ein moduliertes 1-Bit-Signal, insbesondere über eine Pulsweitenmodulation, geregelt.

Beispielsweise kann die Regelung dadurch erfolgen, dass die Ansteuerschaltung 210 ein Ansteuersignal OUT1 abgibt, welches in schneller Folge zwischen dem den ersten und den zweiten Spannungswert U1, U2 wechselt, so dass das Ansteuersignal OUT1 ein 1-Bit-Signal ist, welches aus Pulsen besteht, während welcher das Ansteuersignal OUT1 den Wert U2 annimmt, während es zwischen den Pulsen den Wert U1 annimmt.

Zur erfindungsgemäßen Regelung wird das Tastverhältnis verändert: durch Verlängern dieser Pulse und/oder durch Verkürzen der zeitlichen Zwischenräume zwischen diesen Pulsen wird der Mittelwert des Ansteuersignals OUT1 und damit auch die Steuerspannung Uc vergrößert; umgekehrt wird durch Verkürzen dieser Pulse und/oder durch Verlängern der zeitlichen Zwischenräume zwischen diesen Pulsen der Mittelwert des Ansteuersignals OUT1 und damit auch die Steuerspannung Uc verkleinert.

Erfindungsgemäß stellt die Ansteuerschaltung 210 das Tastverhältnis und somit den Mittelwert des Ansteuersignals OUT1 auf diese Weise so ein, dass die Frequenz f steigt, wenn sie kleiner ist als die Sollfrequenz, und fällt, wenn sie größer ist als die Sollfrequenz, d.h. die Regelung erfolgt über eine Pulsweitenmodulation des 1-Bit-Signals OUT1.

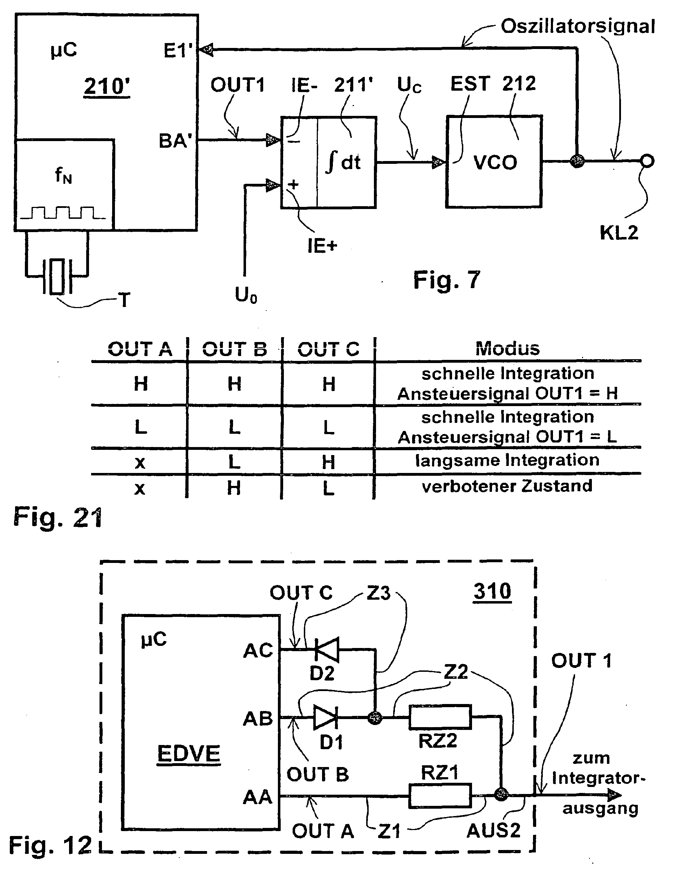

Gemäß einer alternativen Methode wird durch Verändern des Betrages der Differenz OUT1-Uo (vgl. z.B. Fig. 7) die Änderungsgeschwindigkeit der Steuerspannung Uc in weiten Grenzen beeinflusst, z.B. so, dass sich Uc beim Einschalten und nach einem Reset schnell und im Normalbetrieb bzw. ausgeregelten Zustand langsam ändert.

Vorteilhafterweise ist hierbei zwischen der Ansteuerschaltung 210 und dem Integrator 211 lediglich die Übertragung des Ansteuersignals OUT1 erforderlich ist, d.h. der Oszillator 212 wird ausschließlich durch die zeitliche Abfolge des ersten und des zweiten Spannungswertes U1,U2 gesteuert, wozu eine einzige Leitung ausreichend und keinerlei Erkennung von Datenwörtern usw. erforderlich ist.

Gemäß einer weiteren, in Figur 6 nicht gezeigten Variante besitzt die Ansteuerschaltung einen weiteren Eingang E2, auf welchen unten unter Bezug auf Fig. 7 eingegangen wird.

Die Schaltung von Fig. 6 eignet sich insbesondere zur Erzeugung der Erregerspannung für den Ultraschall-Wandler eines Ultraschall-Abstandsmeßsystems, wobei als Sollfrequenz gemäß einer besonders vorteilhaften Ausführungsform der Erfindung die Ausschwingfrequenz des Ultraschallwandlers herangezogen wird. In diesem Fall wird die Oszillatorfrequenz allen zeitlichen Änderungen der Ausschwingfrequenz und damit vorteilhafterweise jeder Drift der Eigenresonanzfrequenz des Ultraschallwandlers automatisch nachgeführt.

Einige Anwendungsmöglichleiten der Erfindung:

- Mikrocontroller-gesteuerte Frequenzerzeugung zum Betrieb von Ultraschallwandlern vorzugsweise auf ihrer Resonanzfrequenz
- Temperaturkompensation der Drift der Wandlereigenresonanz
- Ersatz der konventionellen Oszillatorschaltung mit Potentiometerabgleich zu vergleichbaren Kosten

Fig. 7 zeigt zur Erläuterung einer Ausführungsform der Erfindung eine Abwandlung der Schaltung von Fig. 6 in Form eines schematischen Blockschaltbildes. Auch diese Schaltung kann Bestandteil eines Ultraschall-Abstandsmeßsystems sein. Dargestellt sind ein Mikrocontroller 210' als Ansteuerschaltung, welche die Ansteuerschaltung 210 von Fig. 6 ersetzt, der Oszillator 212 und die Klemme KL2 von Fig. 6 sowie ein Integrator 211', welcher den Integrator 211 von Fig. 6 ersetzt und welcher einen invertierenden Eingang IE- sowie einen nicht invertierenden Eingang IE+ besitzt. An den nicht invertierenden Eingang IE+ ist eine Spannung U0 angelegt, worauf unten noch näher eingegangen wird.

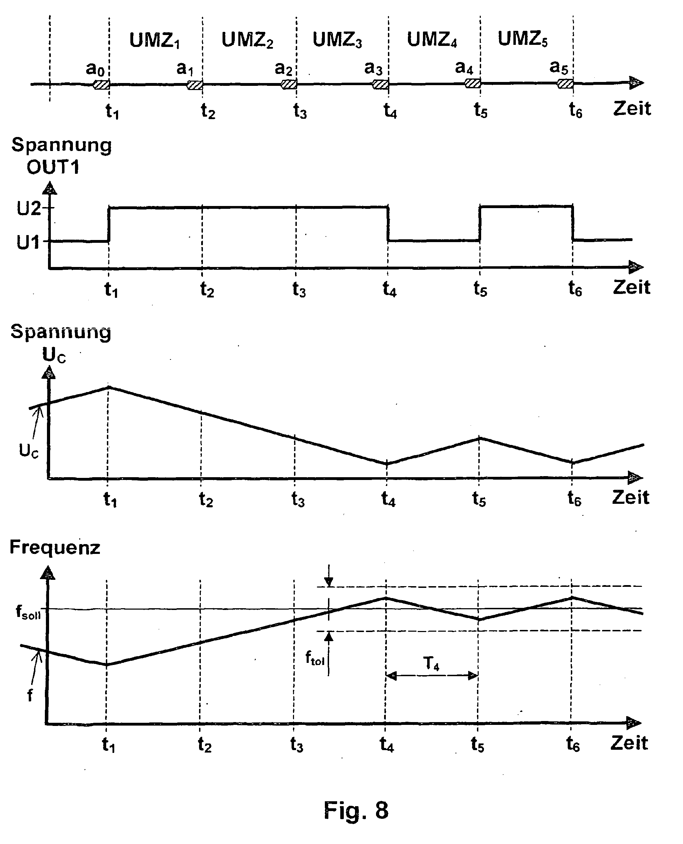

Fig. 8 zeigt während der Ultraschall-Messzyklen $UMZ_1$ bis $UMZ_3$ eines (nicht dargestellten) Ultraschall-Abstandsmeßsystems, in welchem die Schaltung von Fig. 7 eingesetzt ist und zur Erzeugung der Erregerspannung für einen (ebenfalls nicht dargestellten) Schallwandler oder einer hierzu proportionalen Spannung dient, ein Beispiel für das Ausregeln einer Frequenzabweichung durch die Schaltung von Fig. 7. Gezeigt sind Beispiele für den zeitlichen Ablauf von fünf aufeinander folgenden Meßzyklen $UMZ_1$ bis $UMZ_5$ und für jeweils den zeitlichen Verlauf des Ansteuersignals OUT1, der Steuerspannung Uc sowie der Oszillatorfrequenz f im Verlauf der fünf Meßzyklen $UMZ_1$ bis $UMZ_5$. Die Zeitachsen aller Darstellungen in Fig. 8 stimmen untereinander überein.

Der Integrator 211' ist für das vom Ansteuerausgang BA' abgegebene Signal OUT1 ein invertierender Integrator, da dieses Signal im Beispiel von Fig. 7 an den invertierenden Eingang IE- des Integrators 211' angelegt ist. Der Oszillator 212 ist im Beispiel von Fig. 7 ein solcher, dessen Frequenz mit steigender Steuerspannung Uc abnimmt. Der Integrator 211' erzeugt unter Integration des Ansteuersignals OUT1 die Steuerspannung Uc und gibt dieses an den Steuereingang EST des Oszillators 212 bzw. des Steuerwiderstandes RST ab (siehe hierzu auch Fig. 2 -5).

Der Mikrocontroller 210' weist einen mit dem Ausgang des Oszillators 212 verbundenen Eingang E1' auf und ist imstande, über den Eingang E1' die Frequenz des Oszillators 212 in vorgebbaren Zeitabständen für jeweils eine bestimmte Erfassungszeitdauer zu erfassen, und über den Ansteuerausgang BA' das Ansteuersignal OUT1 auf den auf den Integrator-Eingang IE- des Integrators 211' aufzugeben. Die Erfassungszeitdauern sind in Fig. 8 mit den Bezugszeichen ao, $a_1$, $a_2$, $a_3$, $a_4$ und $a_5$ bezeichnet; sie liegen im Beispiel von Fig. 8 jeweils im Bereich des Endes eines Meßzyklus.

Wenn die Oszillatorfrequenz f zum Zeitpunkt ihrer Erfassung größer ist als eine vorgebbare Sollfrequenz $f_{soll}$, gibt der Mikrocontroller 210' über den Ansteuerausgang BA' den ersten Spannungswert U1 auf den invertierenden Eingang IE- des Integrators 211' auf, wodurch die Steuerspannung Uc erhöht und somit die Frequenz f des Oszillators 212 verringert wird. Wenn die Oszillatorfrequenz f zum Zeitpunkt ihrer Erfassung kleiner ist als die Sollfrequenz $f_{soll}$, gibt der Mikrocontroller 210' über den Ansteuerausgang BA' den zweiten Spannungswert U2 auf den invertierenden Eingang IE- des Integrators 211' auf, wodurch sie Steuerspannung Uc verringert und somit die Frequenz f des Oszillators 212 erhöht wird, so dass der Oszillator 212 im auch Beispiel von Fig. 7 ein geregelter Oszillator ist.

An den nicht invertierenden Eingang IE+ des Integrators 211' ist eine solche Referenzspannung Uo angelegt, welche gleich dem arithmetischen Mittel aus dem ersten und dem zweiten Spannungswert U1, U2 ist und welche dazu dient, das zeitliche Verhalten des Integrators 211' bei Anliegen des ersten Spannungswertes U1 gegenüber seinem zeitlichen Verhalten bei Anliegen des zweiten Spannungswertes U2 zu symmetrieren.

Der Mikrocontroller 210' mit dem Eingang E1', welcher mit Hilfe seines eingebauten Hardware-Timers und/ oder geeigneter Software zeitweise als Frequenzzähler arbeitet, sowie mit mindestens dem binären Ausgang BA' steuert die Laufzeitmessung sowie die Erzeugung der Frequenz f. Weiterhin beinhaltet die Erfindung die Verwendung des Integrators 211' und des mit einem Strom oder einer Spannung in der Frequenz gesteuerten Oszillators 212, nachfolgend als VCO bezeichnet. Besondere Ausführungen und Kombinationen des Integrators 211' und des VCO 212 sind Bestandteil der Erfindung.

In einem typischen Ultraschall-Messsystem nach dem Ultraschall-Laufzeitverfahren erfolgt die Messung zyklisch. Dabei wird zu Beginn jedes Zyklus ein Ultraschall-Schwingungspaket ausgesendet und gleichzeitig ein Timer gestartet, welcher die Zeit bis zum Empfang des vom zu detektierenden Objekt reflektierten Echos misst. Am Ende jedes Messzyklus $UMZ_i$ (also z.B. jeweils am Ende der Meßzyklen $UMZ_1, UMZ_2, UMZ_3, UMZ_4, UMZ_5$) wird die Laufzeitmessung abgebrochen (Timeout). Somit steht am Ende jedes Zyklus die Timerschaltung des Mikrocontrollers 210' für andere Aufgaben zur Verfügung.

Erfindungsgemäß wird vorzugsweise einmal zu einem beliebigen Zeitpunkt während jedes Zyklus $UMZ_i$, vorzugsweise aber am Ende des Zyklus, während einer Erfassungszeitdauer $a_i$ vom Mikrocontroller 210' die Frequenz des VCO 212 gemessen (nämlich z.B. während der Erfassungszeitdauern $a_0$ bis $a_5$) und mit einem Sollwert $f_{soll}$ verglichen.

Die Sollfrequenz kann z.B. als Vielfaches der Taktfrequenz des Mikrocontrollers 210' dargestellt werden. Als Frequenznormal dient dabei die Taktfrequenz $f_N$ des Mikrocontrollers 210'. Als Taktgeber für diese Taktfrequenz dient z.B. ein Quarz-Taktgeber T (Fig. 7). Im Ergebnis der Vergleichsoperation wird der binäre Ausgang BA' des Mikrocontrollers 210' gesetzt oder rückgesetzt, so dass für das vom binären Ausgang BA' abgegebene Ansteuersignal OUT1 entweder den Wert U2 oder den Wert U1 annimmt.

Der Integrator 211' mit einer Integrationszeitkonstante $\tau \gg T_i$ ($UMZ_i$) erzeugt aus dieser 1-Bit-Pulsfoge eine Oszillator-Steuerspannung Uc, welche die Frequenz des VCO 212 bestimmt. Dieser geschlossene Regelkreis stellt die Frequenz f des VCO 212 so ein, dass nach einer Zeit $nT_i$ eine Änderung von $f_{soll}$ ausgeregelt wird und dass dann f innerhalb eines Toleranzbandes $f_{tol}$ um die Sollfrequenz $f_{soll}$ pendelt, wobei n eine positive ganze Zahl ist.

Die Zykluszeit $T_i$ muss dazu nicht konstant sein, es ist lediglich sicherzustellen, dass $Ti \leq T_{max}$ nicht überschritten wird. Eine kurzzeitige Unterbrechung des Regelkreises infolge einer Störung (EMI) führt zu einem Verlassen des Toleranzbandes, wobei der Betrag des Fehlers der Unterbrechungszeit proportional ist. Kurzzeitige Unterbrechungen führen so nur zu einem geringen Performance-Verlust, womit das System fehlertolerant ist.

Ab $UMZ_3$ wird im vorliegenden Beispiel (Fig. 8) das Toleranzband $f_{tol}$ erreicht und gehalten. Dazu ist die Integrationszeitkonstante so zu bemessen dass gilt:

$$\Delta f_i(T_i) < f_{tol}/2.$$

VCO: Gängige VCO-IC benutzen spannungsgesteuerte Stromquellen, welche den Ladestrom des Timing-C und damit die Frequenz der Oszillatorschaltung bestimmen. Dieses Prinzip ist aus Aufwandsgründen nur als IC sinnvoll realisierbar. Eine weitere Möglichkeit besteht in der Verwendung eines über einen Integrator rückgekoppelten Schmitt-Triggers, wobei mit der Steuerspannung dessen Hysteresis und damit die Ladezeit des Timing-C und folglich die Frequenz beeinflusst wird. Ein Beispiel für einen solches IC ist das Timer-ICx555. Wird dessen Steuereingang zur Frequenzverstimmung genutzt, bewirkt eine Frequenzverschiebung ebenfalls eine unerwünschte Änderung des Tastverhältnisses. Weiterhin kann bei VCO dieses Typs in herkömmlicher Schaltungstechnik die frequenzbestimmende RC-Zeitkonstante des VCO verstimmt werden, indem als frequenzbestimmender Widerstand ein elektronisch steuerbarer Widerstand eingesetzt wird. Die Ansteuerung dieses Widerstandes gestaltet sich dann schwierig, da er "schwimmend" betrieben wird.

Integrator: Als Integrator gemäß Fig. 7 kommen prinzipiell alle aus der allgemeinen Schaltungstechnik bekannten Lösungen in Frage. In den folgenden Ausgestaltungen der Erfindung kommen zwei Typen von Integratoren zum Einsatz:

1. Das RC-Integrationsglied, nachfolgend als Typ A bezeichnet, wegen seiner Einfachheit und seiner Eigenschaft, für $\tau \gg 1/f$ direkt den Gleichspannungsmittelwert einer Wechselspannung zu bilden.

2. Der aktive invertierende Integrator mit Differenzeingang, nachfolgend als Typ B bezeichnet. Bei diesem Typ wird dem nichtinvertierenden Eingang die Referenzspannung $U_0$ zugeführt. Um bei beiden Zuständen U2, U1 bzw. Hi, Lo von OUT1 den gleichen Betrag des Anstiegs der Ausgangsspannung des Integrators, aber mit entgegengesetztem Vorzeichen, zu erzielen, muss gelten:

$$U_0 = \{OUT1(Hi)-OUT1(Lo)\}/2.$$

Hierbei bedeutet Hi=High-Signal, z.B. U2, und Lo=Low-Signal, z.B. U1.

Das Wirkungsprinzip der Schaltung von Fig. 1 entspricht im wesentlichen derjenigen des Oszillators 212 von Fig. 2 .

Weitere Varianten der Erfindung:

Fig. 9:

Integrator Typ A gemäß Fig. 7 (Bezugszeichen 211') bestehend aus *R1* und *C1*, $R_{var}$ gemäß Fig. 1 bestehend aus dem N-Kanal-JFET *T1*. *+U* ist eine beliebige Hilfsspannung, z.B. die Betriebsspannung des Mikrocontrollers 210' von Fig. 7. Bedingung: *+U > |Up|*, wobei *Up* die Abschnürspannung des JFET ist.

Analog können für T1 P-Kanal-FET eingesetzt werden, dann ist Source mit *GND* statt mit *+U* zu verbinden.

Vorteil: Minimalaufwand.

Das Wirkungsprinzip der Schaltung von Fig. 9 entspricht im wesentlichen derjenigen des Integrators 211A und des Steuerwiderstandes RST von Fig. 3.

Fig. 10:

- Integrator Typ A bestehend aus R1 und C1
- Stromquelle bestehend aus T1 und R2 wandelt die Steuerspannung Uc in den Strom Ic um
- Rvar: T2

Das Wirkungsprinzip der Schaltung von Fig. 10, entspricht im wesentlichen derjenigen des Integrators 211B und des Steuerwiderstandes RST von Fig. 4.

Fig. 11:

- Integrator Typ B bestehend aus R1, R2, R3, C1 und T1.
  Der Emitter von T1 bildet den nichtinvertierenden Eingang. U0 entspricht der Schwellspannung UBE von T1. Der Spannungsteiler R1, R2 sorgt für gleiche Beträge der steigenden und fallenden Rampe von Uc. Integrationszeit-konstante: $\tau = (R1 \parallel R2)C1$

- R4 wandelt die Steuerspannung Uc in den Strom Ic um

  - Rvar: T2

Vorteil: lineare Steuerkennlinie, daher nahezu konstante Steilheit df/dt über den gesamten Steuerbereich.

Das Wirkungsprinzip der Schaltung von Fig. 11 entspricht im wesentlichen derjenigen des Integrators 211 c und des Steuerwiderstandes RST von Fig. 5.

Fig. 12 (unter Bezugnahme auf Fig. 7 und Fig. 8):

Fig. 12 zeigt schematisch eine Ansteuerschaltung 310, welche eine Beeinflussung der Integrationszeit z.B. des Integrators 211' von Fig. 7 mittels diesem vorgeschalteter Bauelemente ermöglicht.

Als Ansteuerschaltung dient gemäß einer bevorzugten Ausführungsform der Erfindung eine Ansteuerschaltung 310 gemäß Fig. 12, welche eine als Mikrocontroller µC ausgebildete EDV-Einrichtung EDVE mit folgenden Komponenten aufweist:

- einen ersten Binäranschluss AA, welcher ein erstes Binärsignal OUTA abgibt und über eine erste Zuleitung Z1, in welcher ein erster Zwischenwiderstand RZ1 zwischengeschaltet ist, mit dem Ansteuerausgang AUS2 verbunden ist,
- einen zweiten Binäranschluss AB, welcher ein zweites Binärsignal OUTB abgibt und über eine zweite Zuleitung Z2, in welcher eine erste Diode D1 und ein dieser in Serie nachgeschalteter zweiter Zwischenwiderstand RZ2 zwischengeschaltet sind, mit dem Ansteuerausgang AUS2 verbunden ist, wobei der zweite Zwischenwiderstand RZ2 einen kleineren Wert aufweist als der erste Zwischenwiderstand RZ1, und die Anode der ersten Diode D1 mit dem zweiten Binäranschluss AB und die Kathode der ersten Diode D1 mit dem zweiten Zwischenwiderstand RZ2 verbunden ist,
- einen dritten Binäranschluss AC, welcher ein drittes Binärsignal OUTC abgibt und mit einer dritten Zuleitung Z3 verbunden ist, welche zwischen der ersten Diode D1 und dem zweiten Zwischenwiderstand von der zweiten Zuleitung Z2 abzweigt und in welcher eine zweite Diode D2 zwischengeschaltet ist, deren Kathode mit dem dritten Binäranschluss AC und deren Anode mit der Kathode der ersten Diode D1 verbunden ist,

wobei

a) das erste, zweite und dritte Binärsignal OUTA,OUTB,OUTC jeweils ein High-Signal oder ein Low-Signal oder eine zeitliche Abfolge von solchen ist,
b) der erste Binäranschluss AA ein High-Signal abgibt, falls die Frequenz des Oszillators 112,212 kleiner ist als die Sollfrequenz, und andernfalls ein Low-Signal abgibt, oder umgekehrt, und
c) die Ansteuerschaltung 310

- in einen ersten Modus, schneller Modus, versetzbar ist, in welchem der zweite und der dritte Binäranschluss AB,AC

  - jeweils dann ein High-Signal abgeben, wenn der erste Binäranschluss AA ein High-Signal abgibt,
  - und jeweils dann ein Low-Signal abgeben, wenn der erste Binäranschluss AA ein Low-Signal abgibt,

so dass der (in Fig. 12 nicht gezeigte) Integrator 211,211',211A, 211B,211C das Ansteuersignal OUT1 mit einer ersten Zeitkonstanten zu der Steuerspannung Uc zu integrieren imstande ist,

- und in einen zweiten Modus, langsamer Modus, versetzbar ist, in welchem der zweite Binäranschluss AB stets ein Low-Signal und der dritte Binäranschluss AC stets ein High-Signal abgibt, so dass der Integrator 211,211',211A, 211B,211C das Ansteuersignal OUT1 mit einer zweiten Zeitkonstanten, welche größer ist als die erste Zeitkonstante, zu der Steuerspannung Uc zu integrieren imstande ist.

Die folgende Tabelle zeigt das gemäß dieser Variante erfolgende Zusammenspiel der Binärsignale OUTA, OUTB und OUTC in Abhängigkeit davon, ob sich die Ansteuerschaltung im schnellen oder im langsamen Modus befindet:

Tabelle 6'

| erstes Binärsignal OUTA | zweites Binärsignal OUTB | drittes Binärsignal OUTC | Modus |
|---|---|---|---|
| High | High | High | schnell |
| Low | Low | Low | schnell |
| High | Low | High | langsam |
| Low | Low | High | langsam |

Die Ansteuerschaltung befindet sich somit im schnellen Modus, wenn das zweite und das dritte Binärsignal beide High-Signale oder beide Low-Signale sind, und im langsamen Modus, wenn das zweite Binärsignal ein Low-Signal und das dritte Binärsignal ein High-Signal ist, wobei die Leerlaufspannung am Ausgang AUS2 jeweils dem Spannungspegel des Binärausgangs AA entspricht.

Die zweite Zeitkonstante kann z.B. um einen Faktor x kleiner sein als die erste Zeitkonstante; dies läßt sich in erster Näherung dadurch erreichen, dass der zweite Zwischenwiderstand RZ2 um den Faktor x kleiner gewählt wird als der erste Zwischenwiderstand RZ1.

Da die zur Erzielung der geforderten Frequenzauflösung nötigen Integrationszeitkonstanten im Bereich von einigen Sekunden liegen, ist eine Zeitkonstantenumschaltung z.B. von $\tau$ auf $\tau/x$ zweckmäßig, um nach dem Einschalten und nach jedem Reset des $\mu$C ein schnelles Einlaufen der Frequenz $f$ in die Umgebung von $f_{soll}$ zu ermöglichen. In der Initialisierungsphase kann das $\mu$C Programm dazu eine Schleife durchlaufen, in der ausschließlich Frequenzmessungen mit verkürzter Messzeit $a_i / x$ und um den Faktor $x$ verringerter Frequenzauflösung durchgeführt werden, z.B. solange bis $f$ eine Umgebung $f_{soll} \pm x^*f_{tol}/2$ erreicht hat. Danach wird die kürzere Zeitkonstante $< / x$ deaktiviert und die normalen Messzyklen $UMZ_i$ beginnen.

Da die Restströme der Ports von Mikrocontrollern im Bereich von 0,1 $\mu$A bis 10 $\mu$A liegen und damit die Integrationszeit unzulässig beeinflussen würden, ist der binäre Ausgang AB mit einer reststromarmen Diode D1 entkoppelt. Um die schnelle Integration in beiden Richtungen durchführen zu können, kann ein weiterer binärer Ausgang AC mit einer Diode D2 verwendet werden. Dann ist z.B. eine logische Steuerung nach der Tabelle von Figur 21 anzuwenden.

Die Ansteuerschaltung 310 von Fig. 12 kann jeweils vorteilhaft anstelle der Ansteuerschaltungen 210 von Fig. 6 und 210' von Fig. 7 eingesetzt werden; in diesen Fällen benötigt die Ansteuerschaltung 310 entsprechende Eingänge und/oder Ausgänge, welche in Bezug auf ihre Funktion denjenigen der Ansteuerschaltungen 210 bzw. 210' entsprechen und in Fig. 12 nicht dargestellt sind. Falls der an die Ansteuerschaltung 310 von Fig. 12 angeschlossene Integrator ein solcher gemäß Fig. 3, 4 oder 5 ist (Bezugszeichen 211A, 211B, 211C), können die Integratorwiderstände IR1 bzw. IR2 bzw. IR3 entfallen.

Das von der Ansteuerschaltung 310 abgegebene Signal OUT1 ist eine zeitliche Abfolge der Spannungswerte U1,U2.

Gewerbliche Anwendbarkeit:

Die Erfindung ist insbesondere gewerblich anwendbar z.B. im Bereich der Funktechnik, der Tontechnik und Ultraschall-Abstandsmessung, welche auf dem Prinzip der Echolaufzeitmessung beruht.

Liste der Bezugzeichen:

| | |
|---|---|
| 3 | Schmitt-Trigger |
| 112,212 | Oszillatoren |
| 210,210',310 | Ansteuerschaltungen |
| 211,211' | Integratoren |
| 211A, 211B, 211C | Ausführungsbeispiele für 211 |
| $a_0,a_1,a_2,a_3,a_4,a_5,a_i$ | Erfassungszeitdauern |
| AA, AB, AC | Binäranschlüsse |
| AUS2, BA, BA' | Ansteuerausgänge |
| E1, E1' | Eingänge von 210, 210' |
| E- | invertierender Eingang von 3 |
| EDVE | EDV-Einrichtung in der Ansteuerschaltung 310 |

| EST | Steuereingang des Steuerwiderstandes RST |
|---|---|
| f | Oszillatorfrequenz |
| $f_{soll}$ | Sollfrequenz |
| $f_{tol}$ | Toleranzband |
| IE, IA | Integratoreingang, Integratorausgang |
| IE+, IE- | nicht invertierender, invertierender Integratoreingang |
| IC1, IC2, IC3 | Integrator-Kondensatoren |
| IR1-IR5 | Integrator-Widerstände |
| IT | Integrator-Transistor |
| KL3 | Klemme |
| OC1, OC2 | Oszillator-Kondensatoren |
| OUTA,OUTB,OUTC | Binärsignale |
| OUT1 | Ansteuersignal |
| Q, Q' | Spannungsquelle, Zusatzspannungsquelle |
| Q" | drittes Potential |
| RR | Rückkopplungswiderstand |
| Rvar, RST | Steuerwiderstände |
| ST1,ST2 | Ausführungsbeispiele für RST |
| RZ1, RZ2 | erster, zweiter Zwischenwiderstand |
| ST1,ST2,ST3,ST4 | Steuertransistoren |
| T | Taktgeber |
| Uo | Referenzspannung |
| U1, U2 | erster, zweiter Spannungswert |
| Uc | Steuerspannung |
| $UMZ_1$-$UMZ_5$, $UMZ_i$ | Meßzyklen |
| VR1, VR2 | Vorwiderstände |

**Patentansprüche**

1. Oszillatorschaltung, mit einem Oszillator (112,212), welcher eine Kippschaltung (3), mit einem Ausgang (A) und einem invertierenden Eingang (E-) umfaßt, wobei

   - der Ausgang (A) über einen Rückkopplungswiderstand (RR) mit dem invertierenden Eingang (E-) verbunden ist,
   - der invertierende Eingang (E-) über einen ersten Oszillator-Kondensator (OC1) an ein erstes Potential gelegt ist,
   - der invertierende Eingang (E-) ferner über einen zweiten Oszillator-Kondensator (OC2) und einen mit diesem in Serie geschalteten Steuerwiderstand (Rvar,RST,ST1,ST2,ST3,ST4), dessen Wert einstellbar oder elektrisch steuerbar ist, an ein zweites Potential gelegt ist,

   so dass die Frequenz (f) des Oszillators (112,212) durch Verändern des Wertes des Steuerwiderstandes (Rvar, RST,ST1,ST2,ST3,ST4) veränderbar ist.

2. Oszillatorschaltung nach Anspruch 1, **dadurch gekennzeichnet, dass**

   - der Steuerwiderstand (ST1), anstatt direkt an das zweite Potential gelegt zu sein, über eine zwischengeschaltete Spannungsquelle (Q) an das zweite Potential gelegt ist, und/oder
   - der erste Oszillatorkondensator (OC1), anstatt direkt an das erste Potential gelegt zu sein, über eine zwischengeschaltete Spannungsquelle an das erste Potential gelegt ist.

3. Oszillatorschaltung nach Anspruch 1 oder 2, **dadurch gekennzeichnet, dass** der Steuerwiderstand (Rvar, RST) durch die Kollektor-Emitter-Strecke bzw. die Drain-Source-Strecke eines Transistors (ST1,ST2), Steuertransistor (ST1,ST2), gebildet ist, an dessen Basis bzw. Gate eine Steuerspannung (Uc) anliegt, so dass

   - der zweite Oszillator-Kondensator (OC2) über die Kollektor-Emitter-Strecke bzw. die Drain-Source-Strecke des Steuertransistors (ST1,ST2) an das zweite Potential, insbesondere an Masse, gelegt ist,
   - und die Frequenz (f) des Oszillators (112,212) durch Verändern der Steuerspannung (Uc) veränderbar ist.

**4.** Oszillatorschaltung nach Anspruch 1 oder 2, **dadurch gekennzeichnet,**
   **dass** der Steuerwiderstand durch die Kollektor-Emitter-Strecke eines Transistors, Steuertransistor, gebildet ist, durch dessen Basis ein Steuerstrom fließt, so dass

   - der zweite Oszillator-Kondensator über die Kollektor-Emitter-Strecke des Steuertransistors an das zweite Potential, insbesondere an Masse, gelegt ist,
   - und die Frequenz des Oszillators durch Verändern des Steuerstromes veränderbar ist.

**5.** Oszillatorschaltung nach Anspruch 3 oder 4, **dadurch gekennzeichnet,**
   **dass** die Kollektor-Emitter-Strecke bzw. die Drain-Source-Strecke des Steuertransistors (ST1,ST2) invers zwischen den zweiten Oszillator-Kondensator (OC2) und das zweite Potential (Q2) zwischengeschaltet ist.

**6.** Oszillatorschaltung nach Anspruch 1 oder 2, **dadurch gekennzeichnet,**
   **dass** der Steuerwiderstand (Rvar, RST) durch die Kollektor-Emitter-Strecke bzw. die Drain-Source-Strecke eines Transistors (ST3,ST4), Steuertransistor (ST3,ST4), gebildet ist, an dessen Emitter bzw. Source eine Steuerspannung (Uc) anliegt und dessen Basis bzw. Gate an ein drittes Potential (Q") gelegt ist, so dass

   - der zweite Oszillator-Kondensator (OC2) über die Kollektor-Emitter-Strecke bzw. die Drain-Source-Strecke des Steuertransistors an die Steuerspannung (Uc) gelegt ist und somit der Steuertransistor in Basisschaltung bzw. Gate-Schaltung angeschlossen ist,
   - und die Frequenz (f) des Oszillators (112,212) durch Verändern der Steuerspannung (Uc) veränderbar ist.

**7.** Oszillatorschaltung nach einem der Ansprüche 1 bis 6, **dadurch gekennzeichnet,**
   **dass** der Wert des Steuerwiderstandes (Rvar,RST,ST1,ST2,ST3,ST4) und damit die Frequenz des Oszillators (112,212) über ein moduliertes 1-Bit-Signal, insbesondere über eine Pulsweitenmodulation, beeinflussbar, steuerbar oder regelbar sind.

**8.** Oszillatorschaltung nach einem der Ansprüche 3, 5 oder 6 sowie nach Anspruch 7, **dadurch gekennzeichnet,**
   **dass** die Steuerspannung (Uc) und damit die Frequenz (f) des Oszillators (112,212) über ein moduliertes 1-Bit-Signal, insbesondere über eine Pulsweitenmodulation, beeinflussbar, steuerbar oder regelbar sind.

**9.** Oszillatorschaltung nach Anspruch 3 und einem der Ansprüche 7 oder 8, **dadurch gekennzeichnet,**
   **dass** die Basis bzw. das Gate des Steuertransistors (ST1,ST2) mit dem Ausgang (IA) eines Integrators (211,211', 211A,211B,211C) verbunden ist, dessen Eingang (IE,IE+,IE-) mit dem Ansteuerausgang (AUS2,BA,BA') einer Ansteuerschaltung (210,210',310) verbunden ist, wobei

   - die Ansteuerschaltung (210,210',310) über den Ansteuerausgang (AUS2,BA,BA') ein Ansteuersignal (OUT1) an den Eingang (IE,IE+,IE-) des Integrators (211,211',211 A,211B,211C) abzugeben imstande ist, welches entweder gleich oder kleiner ist als ein erster Spannungswert (U1) oder gleich oder größer ist als ein zweiter Spannungswert (U2), wobei der erste Spannungswert (U1) kleiner ist als der zweite Spannungswert (U2), und
   - der Integrator (211,211',211A,211B,211C) das Ansteuersignal (OUT1) zu der Steuerspannung (Uc) zu integrieren und diese über den Ausgang (IA) des Integrators (211,211',211A,211B,211C) an die Basis bzw. das Gate des Steuertransistors (ST1,ST2) abzugeben imstande ist,

   so dass

   - entweder die Steuerspannung (Uc) dann abnimmt, wenn das Ansteuersignal (OUT1) gleich oder kleiner ist als der erste Spannungswert (U1), und die Steuerspannung (Uc) dann zunimmt, wenn das Ansteuersignal (OUT1) gleich oder größer ist als der zweite Spannungswert (U2),
   - oder umgekehrt,

   und somit die Frequenz (f) des Oszillators (112,212) oder deren Änderungsgeschwindigkeit durch das Ansteuersignal (OUT1) beeinflussbar oder steuerbar ist.

**10.** Oszillatorschaltung nach Anspruch 8 und 9, **dadurch gekennzeichnet,**
   **dass** das Ansteuersignal (OUT1) ein im wesentlichen rechteckförmig zwischen dem ersten und dem zweiten Spannungswert (U1,U2) wechselndes pulsmoduliertes 1-Bit-Signal ist, so dass

- entweder die Steuerspannung (Uc) verringerbar ist, indem der Mittelwert des Ansteuersignals (OUT1) durch entsprechendes Verändern der zeitlichen Abfolge des ersten und des zweiten Spannungswertes (U1,U2) verkleinert wird, und die Steuerspannung (Uc) erhöhbar ist, indem der Mittelwert des Ansteuersignals (OUT1) durch entsprechendes Verändern der zeitlichen Abfolge des ersten und des zweiten Spannungswertes (U1,U2) vergrößert wird,
- oder umgekehrt,

und somit die Frequenz (f) des Oszillators (112,212) oder deren Änderungsgeschwindigkeit über das pulsmodulierte 1-Bit-Signal beeinflussbar oder steuerbar ist.

11. Oszillatorschaltung nach Anspruch 10, **dadurch gekennzeichnet, dass** das Ansteuersignal (OUT1) ein im wesentlichen rechteckförmig mit einem veränderbaren Tastverhältnis zwischen dem ersten und dem zweiten Spannungswert (U1,U2) wechselndes pulsmoduliertes 1-Bit-Signal ist, dessen Mittelwert durch entsprechendes Verändern des Tastverhältnisses veränderbar ist, so dass das pulsmodulierte 1-Bit-Signal zur Beeinflussung oder Steuerung der Frequenz (f) oder deren Änderungsgeschwindigkeit ein pulsweitenmoduliertes Signal ist.

12. Oszillatorschaltung nach einem der Ansprüche 9 bis 11, **dadurch gekennzeichnet,**
**dass** die Ansteuerschaltung (210,210',310) einen mit dem Ausgang (A) der Kippschaltung bzw. des Schmitt-Triggers (3) verbundenen Eingang (E1,E1') aufweist und imstande ist, die Frequenz (f) des Oszillators (112,212) über den Eingang (E1,E1') zu erfassen und mittels des Ansteuersignals (OUT1) so zu beeinflussen, dass die Frequenz (f) des Oszillators (112,212) sinkt, falls sie größer ist als eine vorgebbare Sollfrequenz (fsoll), und steigt, falls sie kleiner ist als die Sollfrequenz (fsoll), so dass der Oszillator (112,212) ein geregelter Oszillator ist.

13. Oszillatorschaltung nach einem der Ansprüche 9 bis 11 sowie nach Anspruch 12, **dadurch gekennzeichnet,**
**dass** die Ansteuerschaltung (210,210',310) imstande ist, die zeitliche Abfolge des ersten und des zweiten Spannungswertes (U1,U2) so zu verändern, dass

- die Frequenz des Oszillators (112,212) fällt, wenn die Frequenz des Oszillators (112,212) größer ist als die vorgebbare Sollfrequenz (fsoll),
- und die Frequenz des Oszillators (112,212) steigt, wenn die Frequenz des Oszillators (112,212) kleiner ist als die vorgebbare Sollfrequenz (fsoll),

so dass der Oszillator (112,212) ein über eine Pulsmodulation geregelter Oszillator ist.

14. Oszillatorschaltung nach einem der Ansprüche 9 bis 13, **dadurch gekennzeichnet,**
**dass** die Ansteuerschaltung (310) eine EDV-Einrichtung (EDVE) mit folgenden Komponenten aufweist:

- einen ersten Binäranschluss (AA), welcher ein erstes Binärsignal (OUTA) abgibt und über eine erste Zuleitung (Z1), in welcher ein erster Zwischenwiderstand (RZ1) zwischengeschaltet ist, mit dem Ansteuerausgang (AUS2) verbunden ist,
- einen zweiten Binäranschluss (AB), welcher ein zweites Binärsignal (OUTB) abgibt und über eine zweite Zuleitung (Z2), in welcher eine erste Diode (D1) und ein dieser in Serie nachgeschalteter zweiter Zwischenwiderstand (RZ2) zwischengeschaltet sind, mit dem Ansteuerausgang (AUS2) verbunden ist, wobei

- der zweite Zwischenwiderstand (RZ2) einen kleineren Wert aufweist als der erste Zwischenwiderstand (RZ1),
- und die Anode der ersten Diode (D1) mit dem zweiten Binäranschluss (AB) und die Kathode der ersten Diode (D1) mit dem zweiten Zwischenwiderstand (RZ2) verbunden ist,

- einen dritten Binäranschluss (AC), welcher ein drittes Binärsignal (OUTC) abgibt und mit einer dritten Zuleitung (Z3) verbunden ist, welche zwischen der ersten Diode (D1) und dem zweiten Zwischenwiderstand von der zweiten Zuleitung (Z2) abzweigt und in welcher eine zweite Diode (D2) zwischengeschaltet ist, deren Kathode mit dem dritten Binäranschluss (AC) und deren Anode mit der Kathode der ersten Diode (D1) verbunden ist,

wobei

a) das erste, zweite und dritte Binärsignal (OUTA,OUTB,OUTC) jeweils ein High-Signal oder ein Low-Signal oder eine zeitliche Abfolge von solchen ist,

b) der erste Binäranschluss (AA) ein High-Signal abgibt, falls die Frequenz (f) des Oszillators (112,212) kleiner ist als die Sollfrequenz, und andernfalls ein Low-Signal abgibt, oder umgekehrt, und

c) die Ansteuerschaltung (310)

- in einen ersten Modus, schneller Modus, versetzbar ist, in welchem der zweite und der dritte Binäranschluss (AB,AC)

- jeweils dann ein High-Signal abgeben, wenn der erste Binäranschluss (AA) ein High-Signal abgibt,
- und jeweils dann ein Low-Signal abgeben, wenn der erste Binäranschluss (AA) ein Low-Signal abgibt,

so dass der Integrator (211,211',211A,211B,211C) das Ansteuersignal (OUT1) mit einer ersten Zeitkonstanten zu der Steuerspannung (Uc) zu integrieren imstande ist,

- und in einen zweiten Modus, langsamer Modus, versetzbar ist, in welchem der zweite Binäranschluss (AB) stets ein Low-Signal und der dritte Binäranschluss (AC) stets ein High-Signal abgibt, so dass der Integrator (211,211',211A,211B,211C) das Ansteuersignal (OUT1) mit einer zweiten Zeitkonstanten, welche größer ist als die erste Zeitkonstante, zu der Steuerspannung (Uc) zu integrieren imstande ist.

15. Oszillatorschaltung nach einem der Ansprüche 12 bis 14, **dadurch gekennzeichnet,**
**dass** die Ansteuerschaltung (310) imstande ist, nach einem Einschalten oder Reset derselben sich selbsttätig zunächst in den schnellen und

- nach einer bestimmten Zeitdauer
- oder dann, wenn die Frequenz des Oszillators (112,212) einen vorgegebenen Abstand von der Sollfrequenz unterschritten hat,
- oder dann, wenn die Frequenz des Oszillators (112,212) einen vorgegebenen Frequenzbereich erreicht hat,

in den langsamen Modus zu versetzen.

16. Oszillatorschaltung nach einem der Ansprüche 9 bis 15, **dadurch gekennzeichnet,**
**dass** der Integrator (211,211',211A,211B, 211C),

- ein nicht-invertierender Integrator (211A,21B,211C) ist, welcher zusätzlich einen invertierenden Integratoreingang aufweist, an welchen eine Referenzspannung (Uo) angelegt ist,
- oder ein invertierender Integrator (211') ist, welcher zusätzlich einen nichtinvertierenden Integratoreingang aufweist, an welchen eine Referenzspannung (Uo) angelegt ist.

17. Oszillatorschaltung nach Anspruch 16, **dadurch gekennzeichnet,**
**dass** die Referenzspannung (Uo) gleich dem arithmetischen Mittel aus dem ersten und dem zweiten Spannungswert (U1,U2) ist.

18. Oszillatorschaltung nach einem der Ansprüche 12 bis 17, **dadurch gekennzeichnet,**
**dass** die Ansteuerschaltung (210) einen weiteren Eingang (E2) aufweist und imstande ist, über diesen die Frequenz einer Wechselspannung, insbesondere die Ausschwingfrequenz eines Ultraschallwandlers (16), zu erfassen und als Sollfrequenz (fsoll) heranzuziehen.

19. Oszillatorschaltung nach einem der Ansprüche 1 bis 18, **dadurch gekennzeichnet,**
**dass** das erste und das zweite Potential miteinander identisch sind.

20. Oszillatorschaltung nach Anspruch 19, **dadurch gekennzeichnet,**
**dass** das erste und das zweite Potential beide mit Masse identisch sind.

21. Verfahren zur Beeinflussung, Steuerung oder Regelung der Frequenz eines Oszillators (112,212), wobei

- als Oszillator (112,212) ein solcher verwendet wird, welcher eine Kippschaltung (3) mit einem Ausgang (A) und einem invertierenden Eingang (E-) umfaßt,
- der Ausgang (A) über einen Rückkopplungswiderstand (RR) mit dem invertierenden Eingang (E-) verbunden ist,
- der invertierende Eingang (E-) über einen ersten Oszillator-Kondensator (OC1) an ein erstes Potential gelegt ist,
- der invertierende Eingang (E-) ferner über einen zweiten Oszillator-Kondensator (OC2) und einen mit diesem in Serie geschalteten Steuerwiderstand (Rvar,RST,ST1,ST2,ST3,ST4), dessen Wert einstellbar oder elektrisch steuerbar ist, an ein zweites Potential gelegt ist,
- und die Frequenz (f) des Oszillators (112,212) durch Verändern des Wertes des Steuerwiderstandes (Rvar, RST,ST1,ST2,ST3,ST4) verändert wird.

22. Verfahren nach Anspruch 21, **dadurch gekennzeichnet, dass**

- als Steuerwiderstand (ST1,ST2) ein solcher verwendet wird, welcher, anstatt direkt an das zweite Potential gelegt zu sein, über eine zwischengeschaltete Spannungsquelle (Q) an das zweite Potential gelegt ist, und/oder
- als erster Oszillatorkondensator (OC1) ein solcher verwendet wird, welcher, anstatt direkt an das erste Potential gelegt zu sein, über eine zwischengeschaltete Spannungsquelle an das erste Potential gelegt ist.

23. Verfahren nach Anspruch 21 oder 22, **dadurch gekennzeichnet, dass**

- als Steuerwiderstand (Rvar,RST) die Kollektor-Emitter-Strecke bzw. die Drain-Source-Strecke eines Transistors (ST1,ST2), Steuertransistor (ST1,ST2), verwendet wird, so dass der zweite Oszillator-Kondensator (OC2) über die Kollektor-Emitter-Strecke bzw. die Drain-Source-Strecke des Steuertransistors (ST1,ST2) an das zweite Potential, insbesondere an Masse, gelegt ist,
- an die Basis bzw. das Gate des Steuertransistors (ST1,ST2) eine Steuerspannung (Uc) angelegt wird,
- und die Frequenz des Oszillators (112,212) durch Verändern der Steuerspannung (Uc), verändert wird.

24. Verfahren nach Anspruch 21 oder 22, **dadurch gekennzeichnet, dass**

- als Steuerwiderstand die Kollektor-Emitter-Strecke eines Transistors, Steuertransistor, verwendet wird, durch dessen Basis ein Steuerstrom fließt, so dass der zweite Oszillator-Kondensator über die Kollektor-Emitter-Strecke des Steuertransistors an das zweite Potential, insbesondere an Masse, gelegt ist,
- und die Frequenz des Oszillators durch Verändern des Steuerstromes verändert wird.

25. Oszillatorschaltung nach Anspruch 23 oder 24, **dadurch gekennzeichnet, dass** die Kollektor-Emitter-Strecke bzw. die Drain-Source-Strecke des Steuertransistors (ST1,ST2) invers betrieben wird.

26. Oszillatorschaltung nach Anspruch 21 oder 22, **dadurch gekennzeichnet,**
**dass** der Steuerwiderstand (Rvar, RST) durch die Kollektor-Emitter-Strecke bzw. die Drain-Source-Strecke eines Transistors (ST3,ST4), Steuertransistor (ST3,ST4), gebildet ist, an dessen Emitter bzw. Source eine Steuerspannung (Uc) angelegt wird und dessen Basis bzw. Gate an ein drittes Potential (Q") gelegt ist, so dass

- der zweite Oszillator-Kondensator (OC2) über die Kollektor-Emitter-Strecke bzw. die Drain-Source-Strecke des Steuertransistors an das zweite Potential gelegt ist und somit der Steuertransistor in Basisschaltung bzw. Gate-Schaltung betrieben wird,
- und die Frequenz (f) des Oszillators (112,212) durch Verändern der Steuerspannung (Uc) verändert wird.

27. Verfahren nach einem der Ansprüche 21 bis 26, **dadurch gekennzeichnet,**
**dass** der Wert des Steuerwiderstandes (Rvar,RST,ST1,ST2,ST3,ST4) und damit die Frequenz (f) des Oszillators (112,212) über ein moduliertes 1-Bit-Signal, insbesondere über eine Pulsweitenmodulation, beeinflusst, gesteuert oder geregelt werden.

28. Verfahren nach Anspruch 23 oder 26, **dadurch gekennzeichnet,**
**dass** die Steuerspannung (Uc) und damit die Frequenz (f) des Oszillators (112,212) über ein moduliertes 1-Bit-Signal, insbesondere über eine Pulsweitenmodulation, beeinflusst, gesteuert, oder geregelt wird.

29. Verfahren nach einem der Ansprüche 23 bis 28, **dadurch gekennzeichnet,**
**dass** als Steuertransistor (ST1,ST2) ein solcher verwendet wird, dessen Basis bzw. Gate mit dem Ausgang (IA) eines Integrators (211,211',211A,211B,211C) verbunden ist, dessen Eingang (IE,IE+,IE-) mit dem Ansteuerausgahg (AUS2,BA,BA') einer Ansteuerschaltung (210,210',310) verbunden ist, wobei

- als Ansteuerschaltung (210,210',310) eine solche verwendet wird, welche über den Ansteuerausgang (AUS2,BA,BA') ein Ansteuersignal (OUT1) an den Eingang (IE,IE+,IE-) des Integrators (211,211',211A,211B, 211C) abzugeben imstande ist, welches entweder gleich oder kleiner ist als ein erster Spannungswert (U1) oder gleich oder größer ist als ein zweiter Spannungswert (U2), wobei der erste Spannungswert (U1) kleiner ist als der zweite Spannungswert (U2), und
- als Integrator (211,211',211A,211B,211C) ein solcher verwendet wird, welcher das Ansteuersignal (OUT1) zu der Steuerspannung (Uc) zu integrieren und diese über den Ausgang (IA) des Integrators (211,211',211A, 211B,211C) an die Basis bzw. das Gate des Steuertransistors (ST1,ST2) abzugeben imstande ist,

und wobei entweder

- die Steuerspannung (Uc) verringerbar ist, indem die Ansteuerschaltung (210,210',310) so gesteuert wird, dass das Ansteuersignal (OUT1) gleich oder kleiner ist als der erste Spannungswert (U1),
- und die Steuerspannung (Uc) erhöhbar ist, indem die Ansteuerschaltung (210,210',310) so gesteuert wird, dass das Ansteuersignal (OUT1) gleich oder größer ist als der zweite Spannungswert (U2),

oder umgekehrt, so dass die Frequenz (f) des Oszillators (112,212) oder deren Änderungsgeschwindigkeit durch das Ansteuersignal (OUT1) beeinflusst oder gesteuert wird.

30. Verfahren nach Anspruch 28 und 29, **dadurch gekennzeichnet,**
**dass** als Ansteuersignal (OUT1) ein im wesentlichen rechteckförmig zwischen dem ersten und dem zweiten Spannungswert (U1,U2) wechselndes pulsmoduliertes 1-Bit-Signal verwendet wird, so dass

- entweder die Steuerspannung (Uc) verringerbar ist, indem der Mittelwert des Ansteuersignals (OUT1) durch entsprechendes Verändern der zeitlichen Abfolge des ersten und des zweiten Spannungswertes (U1,U2) verkleinert wird, und die Steuerspannung (Uc) erhöhbar ist, indem der Mittelwert des Ansteuersignals (OUT1) durch entsprechendes Verändern der zeitlichen Abfolge des ersten und des zweiten Spannungswertes (U1,U2) vergrößert wird,
- oder umgekehrt,

und die Frequenz (f) des Oszillators (112,212) oder deren Änderungsgeschwindigkeit über das pulsmodulierte 1-Bit-Signal beeinflusst oder gesteuert wird.

31. Verfahren nach Anspruch 30, **dadurch gekennzeichnet, dass** als Ansteuersignal (OUT1) ein im wesentlichen rechteckförmig mit einem veränderbaren Tastverhältnis zwischen dem ersten und dem zweiten Spannungswert (U1,U2) wechselndes pulsmoduliertes 1-Bit-Signal verwendet wird, dessen Mittelwert durch entsprechendes Verändern des Tastverhältnisses veränderbar ist, so dass die Frequenz (f) des Oszillators (112,212) oder deren Änderungsgeschwindigkeit durch eine Pulsweitenmodulation beeinflusst oder gesteuert wird.

32. Verfahren nach einem der Ansprüche 29 bis 31, **dadurch gekennzeichnet, dass**

- als Ansteuerschaltung (210,210',310) eine solche verwendet wird, welche einen mit dem Ausgang (A) der Kippschaltung bzw. des Schmitt-Triggers (3) verbundenen Eingang (E1,E1') aufweist, über welchen die Frequenz (f) des Oszillators (112,212) erfasst wird,
- und die Frequenz (f) des Oszillators (112,212) mittels des Ansteuersignals (OUT1) so beeinflusst wird, dass sie sinkt, falls sie größer ist als eine vorgebbare Sollfrequenz (fsoll), und steigt, falls sie kleiner ist als die Sollfrequenz (fsoll),

so dass die Frequenz (f) des Oszillator (112,212) über die Ansteuerschaltung (210,210',310) geregelt wird.

33. Verfahren nach einem der Ansprüche 29 bis 31 sowie nach Anspruch 32, **dadurch gekennzeichnet,**
**dass** die zeitliche Abfolge des ersten und des zweiten Spannungswertes (U1,U2) so verändert wird, dass

- die Frequenz des Oszillators (112,212) fällt, wenn die Frequenz des Oszillators (112,212) größer ist als die vorgebbare Sollfrequenz (fsoll),
- und die Frequenz des Oszillators (112,212) steigt, wenn die Frequenz des Oszillators (112,212) kleiner ist als die vorgebbare Sollfrequenz (fsoll),

so dass der Oszillator (112,212) über eine Pulsmodulation geregelt wird.

34. Verfahren nach einem der Ansprüche 29 bis 33, **dadurch gekennzeichnet, dass** als Ansteuerschaltung (310) eine solche verwendet wird, welche eine EDV-Einrichtung (EDVE) mit folgenden Komponenten aufweist:

- einen ersten Binäranschluss (AA), welcher ein erstes Binärsignal (OUTA) abgibt und über eine erste Zuleitung (Z1), in welcher ein erster Zwischeriwiderstand (RZ1) zwischengeschaltet ist, mit dem Ansteuerausgang (AUS2) verbunden ist,
- einen zweiten Binäranschluss (AB), welcher ein zweites Binärsignal (OUTB) abgibt und über eine zweite Zuleitung (Z2), in welcher eine erste Diode (D1) und ein dieser in Serie nachgeschalteter zweiter Zwischenwiderstand (RZ2) zwischengeschaltet sind, mit dem Ansteuerausgang (AUS2) verbunden ist, wobei

- der zweite Zwischenwiderstand (RZ2) einen kleineren Wert aufweist als der erste Zwischenwiderstand (RZ1),
- und die Anode der ersten Diode (D1) mit dem zweiten Binäranschluss (AB) und die Kathode der ersten Diode (D1) mit dem zweiten Zwischenwiderstand (RZ2) verbunden ist,

- einen dritten Binäranschluss (AC), welcher ein drittes Binärsignal (OUTC) abgibt und mit einer dritten Zuleitung (Z3) verbunden ist, welche zwischen der ersten Diode (D1) und dem zweiten Zwischenwiderstand von der zweiten Zuleitung (Z2) abzweigt und in welcher eine zweite Diode (D2) zwischengeschaltet ist, deren Kathode mit dem dritten Binäranschluss (AC) und deren Anode mit der Kathode der ersten Diode (D1) verbunden ist,

wobei

a) das erste, zweite und dritte Binärsignal (OUTA,OUTB,OUTC) jeweils ein High-Signal oder ein Low-Signal oder eine zeitliche Abfolge von solchen ist,
b) der erste Binäranschluss (AA) ein High-Signal abgibt, falls die Frequenz des Oszillators (112,212) kleiner ist als die Sollfrequenz, und andernfalls ein Low-Signal abgibt, oder umgekehrt, und
c) die Ansteuerschaltung (310)

- in einen ersten Modus, schneller Modus, versetzbar ist, in welchem der zweite und der dritte Binäranschluss (AB,AC)

- jeweils dann ein High-Signal abgeben, wenn der erste Binäranschluss (AA) ein High-Signal abgibt,
- und jeweils dann ein Low-Signal abgeben, wenn der erste Binäranschluss (AA) ein Low-Signal abgibt,

so dass der Integrator (211,211',211A,211B,211C) das Ansteuersignal (OUT1) mit einer ersten Zeitkonstanten zu der Steuerspannung (Uc) zu integrieren imstande ist,
- und in einen zweiten Modus, langsamer Modus, versetzbar ist, in welchem der zweite Binäranschluss (AB) stets ein Low-Signal und der dritte Binäranschluss (AC) stets ein High-Signal abgibt, so dass der Integrator (211,211',211A,211B,211C) das Ansteuersignal (OUT1) mit einer zweiten Zeitkonstanten, welche größer ist als die erste Zeitkonstante, zu der Steuerspannung (Uc) zu integrieren imstande ist.

35. Verfahren nach Anspruch 34, **dadurch gekennzeichnet,**
**dass** die Ansteuerschaltung (310) nach einem Einschalten oder Reset derselben automatisch zunächst in den schnellen und

- nach einer bestimmten Zeitdauer
- oder dann, wenn die Frequenz des Oszillators (112,212) einen vorgegebenen Abstand von der Sollfrequenz unterschritten hat,
- oder dann, wenn die Frequenz des Oszillators (112,212) einen vorgegebenen Frequenzbereich erreicht hat,

in den langsamen Modus versetzt wird.

36. Verfahren nach einem der Ansprüche 29 bis 35; **dadurch gekennzeichnet, dass** als Integrator (211,211',211A, 211B,21C),

- ein nicht-invertierender Integrator (211A,211B,211C) verwendet wird, welcher zusätzlich einen invertierenden Integratoreingang aufweist, an welchen eine Referenzspannung (Uo) angelegt wird,
- oder ein invertierender Integrator (211') verwendet wird, welcher zusätzlich einen nicht-invertierenden Integratoreingang aufweist, an welchen eine Referenzspannung (Uo) angelegt wird.

**37.** Verfahren nach Anspruch 36, **dadurch gekennzeichnet,**
**dass** eine solche Referenzspannung (Uo) an den zusätzlichen Integratoreingang angelegt wird, welche gleich dem arithmetischen Mittel aus dem ersten und dem zweiten Spannungswert (U1,U2) ist.

**38.** Verfahren nach einem der Ansprüche 31 bis 34, **dadurch gekennzeichnet,**
**dass** als Sollfrequenz die Frequenz einer Wechselspannung, insbesondere die Ausschwingfrequenz eines Ultraschallwandlers (16), verwendet wird.

**Claims**

**1.** An oscillator circuit including an oscillator (112, 212) comprising a toggle circuit (3) having an output (A) and an inverting input (E-), wherein

- said output (A) is connected to the inverting input (E-) via a feedback resistor (RR),
- said inverting input (E-) is coupled to a first potential via a first oscillator capacitor (OC1),
- said inverting input (E-) is also coupled to a second potential via a second oscillator capacitor (OC2) and a control resistor (Rvar, RST, ST1, ST2, ST3, ST4) which is connected in series to said second oscillator capacitor and whose value can be adjusted or electrically controlled,

so that a frequency (f) of said oscillator (112, 212) can be varied by changing the value of said control resistor (Rvar, RST, ST1, ST2, ST3, ST4).

**2.** The oscillator circuit according to claim 1, **characterized in that**

- said control resistor (ST1) is coupled to said second potential via an interconnected voltage source (Q) rather than being directly coupled to said second potential and/or
- said first oscillator capacitor (OC1) is coupled to said first potential via an interconnected voltage source rather than being directly coupled to said first potential.

**3.** The oscillator circuit according to claim 1 or claim 2, **characterized in that**

- said control resistor (Rvar, RST) is comprised of a collector-emitter path or a drain-source path of a transistor (ST1, ST2), control transistor (ST1, ST2), having a control voltage (Uc) applied at its base or gate, so that
- said second oscillator capacitor (OC2) is coupled to said second potential, in particular to ground, via said collector-emitter path or via said drain-source path of the control transistor (ST1, ST2),
- and the frequency (f) of the oscillator (112, 212) can be varied by changing the control voltage (Uc).

**4.** The oscillator circuit according to claim 1 or 2, **characterized in that** said control resistor is comprised of the collector-emitter path of a transistor, control transistor, having a control current flowing through a base of it, so that

- the second oscillator capacitor is coupled to the second potential, in particular to ground, via the collector-emitter path of the control transistor,
- and the frequency of the oscillator can be varied by changing the control current.

**5.** The oscillator circuit according to claim 3 or 4, **characterized in that** the collector-emitter path or the drain-source path of the control transistor (ST1, ST2) is inversely interconnected between the second oscillator capacitor (OC2) and the second potential (Q2).

**6.** The oscillator circuit according to claim 1 or 2, **characterized in that** the control resistor (Rvar, RST) is comprised of the collector-emitter path or the drain-source path of a transistor (ST3, ST4), control transistor (ST3, ST4), having a control voltage (Uc) applied at its emitter or source and having its base or gate coupled to a third potential (Q"), so that

- the second oscillator capacitor (OC2) is coupled to the control voltage (Uc) via the collector-emitter path or the drain-source path of the control transistor, the control transistor therefore being base- or gate-connected,
- and the frequency (f) of the oscillator (112, 212) can be varied by changing the control voltage (Uc).

**7.** The oscillator circuit according to any of claims 1 to 6, **characterized in that**

the value of the control resistor (Rvar, RST, ST1, ST2, ST3, ST4) and thus the frequency of the oscillator (112, 212) can be influenced, controlled or adjusted by a modulated 1-bit signal, in particular by pulse width modulation.

8. The oscillator circuit according to any of claims 3, 5 or 6 and claim 7, **characterized in that** the control voltage (Uc) and thus the frequency (f) of the oscillator (112, 212) can be influenced, controlled or adjusted by a modulated 1-bit signal, in particular by pulse width modulation.

9. The oscillator circuit according to claim 3 and any of claims 7 or 8, **characterized in that** the base or gate of the control transistor (ST1, ST2) is coupled to the output (IA) of an integrator (211, 211', 211A, 211B, 211C) having its input (IE, IE+, IE-) coupled to a trigger output (AUS2, BA, BA') of a trigger circuit (210, 210', 310), wherein

   - the trigger circuit (210, 210', 310) is capable of delivering a trigger signal (OUT1) to the input (IE, IE+, IE-) of the integrator (211, 211', 211A, 211B, 211C) via the trigger output (AUS2, BA, BA'), said trigger signal being either equal to or smaller than a first voltage value (U1) or equal to or greater than a second voltage value (U2), said first voltage value (U1) being smaller than said second voltage value (U2), and
   - the integrator (211, 211', 211A, 211B, 211C) is capable of integrating the trigger signal (OUT1) into the control voltage (Uc) and of delivering he latter via the output (IA) of the integrator (211, 211', 211A, 211B, 211C) to the base or gate of the control transistor (ST1, ST2),

   so that

   - either the control voltage (Uc) drops if the trigger signal (OUT1) is equal to or smaller than the first voltage value (U1), and the control voltage (Uc) rises if the trigger signal (OUT1) is equal to or greater than the second voltage value (U2),
   - or vice versa,

   and thus the frequency (f) of the oscillator (112, 212) or its rate of change can be influenced or controlled by the trigger signal (OUT1).

10. The oscillator circuit according to claim 8 or 9, **characterized in that** the trigger signal (OUT1) is a pulse-modulated 1-bit signal that alternates essentially like a square wave between the first and second voltage values (U1, U2), so that

    - either the control voltage (Uc) can be lowered by decreasing the mean value of the trigger signal (OUT1) by appropriately changing the time sequence of the first and second voltage values (U1, U2), and the control voltage (Uc) can be raised by increasing the mean value of the trigger signal (OUT1) by appropriately changing the time sequence of the first and second voltage values (U1, U2),
    - or vice versa,

    and thus the frequency (f) of the oscillator (112, 212) or its rate of change can be influenced or controlled by the pulse-modulated 1-bit signal.

11. The oscillator circuit according to claim 10, **characterized in that** the trigger signal (OUT1) is a pulse-modulated 1-bit signal that alternates essentially like a square wave with a variable duty cycle between the first and second voltage values (U1, U2), wherein the mean value of said signal can be varied by appropriately changing its duty cycle, so that the pulse-modulated 1-bit signal for influencing or controlling a frequency (f) or its rate of change is a pulse-width-modulated signal.

12. The oscillator circuit according to any of claims 9 to 11, **characterized in that** the trigger circuit (210, 210', 310) has an input (E1, E1') that is connected to the output (A) of the toggle circuit or Schmitt trigger (3), respectively, and said control circuit is capable of detecting the frequency (f) of the oscillator (112, 212) via the input (E1, E1') and of influencing said frequency by the trigger signal (OUT1) in such a way that the frequency (f) of the oscillator (112, 212) decreases if it is greater than a presettable target frequency (ftgt) and increases if it is smaller than the target frequency (ftgt), so that the oscillator (112, 212) is a feedback-controlled oscillator.

13. The oscillator circuit according to any of claims 9 to 11 and claim 12, **characterized in that** the trigger circuit (210, 210', 310) is capable of changing the time sequence of the first and second voltage values (U1, U2) in such a way that

- the frequency of the oscillator (112, 212) decreases if the frequency of the oscillator (112, 212) is greater than the presettable target frequency (ftgt),
- and the frequency of the oscillator (112, 212) increases if the frequency of the oscillator (112, 212) is smaller than the presettable target frequency (ftgt),

so that the oscillator (112, 212) is a pulse-modulated oscillator.

14. The oscillator circuit according to one of claims 9 to 13, **characterized in that** the trigger circuit (310) has an electronic data processing equipment (EDPE) comprising the following components:

- a first binary junction (AA) that emits a first binary signal (OUTA) and that is connected to the trigger output (AUS2) via a first feed line (Z1) having interposed therein a first intermediate resistor (RZ1),
- a second binary junction (AB) that emits a second binary signal (OUTB) and that is connected to the trigger output (AUS2) via a second feed line (Z2) having interposed therein a first diode (D1) and a second intermediate resistor (RZ2) coupled in series downstream from said first diode, wherein
- the second intermediate resistor (RZ2) has a smaller value than the first intermediate resistor (RZ1),
- and the anode of the first diode (D1) is connected to the second binary junction (AB) and the cathode of the first diode (D1) is connected to the second intermediate resistor (RZ2),
- a third binary junction (AC) that emits a third binary signal (OUTC) and that is connected to a third feed line (Z3) branching off from the second feed line (Z2) between the first diode (D1) and the second intermediate resistor and having a second diode (D2) interposed therein whose cathode is coupled to the third binary junction (AC) and whose anode is coupled to the cathode of the first diode (D1),

wherein

a) each of said first, second and third binary signals (OUTA, OUTB, OUTC) is either a high-signal or a low-signal or a time sequence of such signals,
b) the first binary junction (AA) emits a high-signal if the frequency (f) of the oscillator (112, 212) is smaller than the target frequency, and otherwise emits a low-signal, or vice versa, and
c) the trigger circuit (310)

- can be set into a first mode, fast mode, in which each of said second and third binary junctions (AB, AC)

- emit a high-signal if the first binary junction (AA) emits a high-signal,
- and emit a low-signal if the first binary junction (AA) emits a low-signal,

so that the integrator (211, 211', 211A, 211B, 211C) is capable of integrating the trigger signal (OUT1) with a first time constant into the control voltage (Uc),
- and can be set into a second mode, slow mode, in which the second binary junction (AB) always emits a low-signal and the third binary junction (AC) always emits a high-signal, so that the integrator (211, 211', 211A, 211B, 211C) is capable of integrating the trigger signal (OUT1) with a second time constant that is greater than the first time constant, into the control voltage (Uc).

15. The oscillator circuit according to one of claims 12 to 14, **characterized in that** the trigger circuit (310) is capable of autonomously entering the fast mode upon switch-on or reset, and then shifting to slow mode

- after a certain period of time has elapsed,
- or if the frequency of the oscillator (112, 212) comes below a predefined distance from the target frequency,
- or if the frequency of the oscillator (112, 212) reaches a predefined frequency range.

16. The oscillator circuit according to one of claims 9 to 15, **characterized in that** the integrator (211, 211', 211A, 211B, 211C) is

- a non-inverting integrator (211A, 211B, 211C) that has an additional inverting integrator input at which a reference voltage (Uo) is applied,
- or an inverting integrator (211') that has an additional non-inverting integrator input at which a reference voltage (Uo) is applied.

**17.** The oscillator circuit according to claim 16, **characterized in that** said reference voltage (Uo) is equal to the arithmetic mean of the first and second voltage values (U1, U2).

**18.** The oscillator circuit according to one of claims 12 to 17, **characterized in that** the trigger circuit (210) has another input (E2) and, via this input, is capable of detecting the frequency of an alternating voltage, in particular a decay frequency of an ultrasonic transducer (16), and of taking it as the target frequency (ftgt).

**19.** The oscillator circuit according to one of claims 1 to 18, **characterized in that** the first and the second potentials are identical to each other.

**20.** The oscillator circuit according to claim 19, **characterized in that** the first and the second potentials are both identical to ground.

**21.** A method for influencing, controlling or adjusting the frequency of an oscillator (112, 212), wherein

- the oscillator (112, 212) employed is one that comprises a toggle circuit (3) having an output (A) and an inverting input (E-),
- the output (A) is connected to the inverting input (E-) via a feedback resistor (RR),
- the inverting input (E-) is coupled to a first potential via a first oscillator capacitor (OC1),
- the inverting input (E-) is also coupled to a second potential via a second oscillator capacitor (OC2) and via a control resistor (Rvar, RST, ST1, ST2, ST3, ST4) which is coupled in series to said second oscillator capacitor and whose value can be adjusted or electrically controlled,
- and the frequency (f) of the oscillator (112, 212) is varied by changing the value of the control resistor (Rvar, RST, ST1, ST2, ST3, ST4).

**22.** The method according to claim 21, **characterized in that**

- the control resistor (ST1, ST2) employed is one that is coupled to the second potential via an interconnected voltage source (Q) rather than being directly coupled to the second potential, and/or
- the first oscillator (OC1) employed is one that is coupled to the first potential via an interconnected voltage source rather than being directly coupled to the first potential.

**23.** The method according to any of claims 21 and 22, **characterized in that**

- the collector-emitter path or the drain-source path of a transistor (ST1, ST2), control transistor (ST1, ST2), is used as the control resistor (Rvar, RST), so that the second oscillator capacitor (OC2) is coupled to the second potential, in particular to ground, via the collector-emitter path or via the drain-source path of the control transistor (ST1, ST2),
- a control voltage (Uc) is applied at the base or gate of the control transistor (ST1, ST2),
- and the frequency of the oscillator (112, 212) is varied by changing the control voltage (Uc).

**24.** The method according to any of claims 21 or 22, **characterized in that**

- the collector-emitter path of a transistor, control transistor, having a current flow passed through its base, is used as the control resistor, so that the second oscillator capacitor is coupled to the second potential, in particular to ground, via the collector-emitter path of the control transistor,
- and the frequency of the oscillator is varied by changing the control current.

**25.** The oscillator circuit according to any of claims 23 or 24, **characterized in that** the collector-emitter path or the drain-source path of the control transistor (ST1, ST2) is operated inversely.

**26.** The oscillator circuit according to one of claims 21 or 22, **characterized in that** the control resistor (Rvar, RST) is comprised of the collector-emitter path or the drain-source path of a transistor (ST3, ST4), control transistor (ST3, ST4), having a control voltage (Uc) applied at its emitter or source and having its base or gate coupled to a third potential (Q"), so that

- the second oscillator capacitor (OC2) is coupled to the second potential via the collector-emitter path or the drain-source path of the control transistor, the control transistor therefore being base- or gate-operated,

- and the frequency (f) of the oscillator (112, 212) is varied by changing the control voltage (Uc).

27. The method according to any of claims 21 to 26, **characterized in that** the value of the control resistor (Rvar, RST, ST1, ST2, ST3, ST4) and thus the frequency (f) of the oscillator (112, 212) are influenced, controlled or adjusted via a modulated 1-bit signal, in particular via pulse width modulation.

28. The method according to any of claims 23 and 26, **characterized in that** the control voltage (Uc) and thus the frequency (f) of the oscillator (112, 212) are influenced, controlled or adjusted via a modulated 1-bit signal, in particular via pulse width modulation.

29. The method according to any of claims 23 to 28, **characterized in that** the control resistor (ST1, ST2) employed is one whose base or gate is connected to the output (IA) of an integrator (211, 211', 211A, 211B, 211C) whose input (IE, IE+, IE-) is coupled to the trigger output (AUS2, BA, BA') of a trigger circuit (210, 210', 310), wherein

    - the trigger circuit (210, 210', 310) employed is one that is capable of delivering a trigger signal (OUT1) to the input (IE, IE+, IE-) of the integrator (211, 211', 211A, 211B, 211C) via the trigger output (AUS2, BA, BA'), said control signal being either equal to or smaller than a first voltage value (U1) or equal to or greater than a second voltage value (U2), wherein the first voltage value (U1) is smaller than the second voltage value (U2), and
    - the integrator (211, 211', 211A, 211B, 211C) employed is one that is capable of integrating the trigger signal (OUT1) into the control voltage (Uc) and of delivering the latter to the base or gate of the control transistor (ST1, ST2) via the output (IA) of the integrator (211, 211', 211A, 211B, 211C),

    and wherein either

    - the control voltage (Uc) can be lowered by controlling the trigger circuit (210, 210', 310) so that the trigger signal (OUT1) is equal to or smaller than the first voltage value (U1),
    - and the control voltage (Uc) can be raised by controlling the trigger circuit (210, 210', 310) so that that the trigger signal (OUT1) is equal to or greater than the second voltage value (U2),

    or vice versa, so that the frequency (f) of the oscillator (112, 212) or its rate of change is influenced or controlled by the trigger signal (OUT1).

30. The method according to any of claims 28 and 29, **characterized in that** a pulse-modulated 1-bit signal that alternates essentially like a square wave between the first and second voltage values (U1, U2) is used as the trigger signal (OUT1), so that

    - either the control voltage (Uc) can be lowered by decreasing the mean value of the trigger signal (OUT1) by appropriately changing the time sequence of the first and second voltage values (U1, U2), and the control voltage (Uc) can be raised by increasing the mean value of the trigger signal (OUT1) by appropriately changing the time sequence of the first and second voltage values (U1, U2)

    or vice versa,
    and the frequency (f) of the oscillator (112, 212) or its rate of change is influenced or controlled via the pulse-modulated 1-bit signal.

31. The method according to claim 30, **characterized in that**
    a pulse-modulated 1-bit signal oscillating essentially like a square wave with a variable duty cycle between the first and second voltage values (U1, U2) can be used as the trigger signal (OUT1), wherein the mean value of said signal can be varied by appropriately changing the duty cycle, so that the frequency (f) of the oscillator (112, 212) or its rate of change is influenced or controlled by pulse-width modulation.

32. The method according to any of claims 29 to 31, **characterized in that**

    - the trigger circuit (210, 210', 310) employed is one that has an input (E1, E1') that is coupled to the output (A) of the toggle circuit or Schmitt trigger (3), respectively, which serves to detect the frequency (f) of the oscillator (112, 212),
    - and the frequency (f) of the oscillator (112, 212) is influenced by the trigger signal (OUT1) in such a way that it decreases if it is greater than a presettable target frequency (ftgt), and it increases if it is smaller than the target frequency (ftgt),

so that the frequency (f) of the oscillator (112, 212) is adjusted via the trigger circuit (210, 210', 310).

33. The method according to any of claims 29 to 31 and according to claim 32, **characterized in that** the time sequence of the first and second voltage values (U1, U2) is changed in so that

   - the frequency of the oscillator (112, 212) decreases if the frequency of the oscillator (112, 212) is greater than the presettable target frequency (ftgt),
   - and the frequency of the oscillator (112, 212) increases if the frequency of the oscillator (112, 212) is smaller than the presettable target frequency,

   so that the oscillator (112, 212) is adjusted via pulse modulation.

34. The method according to one of claims 29 to 33, **characterized in that** the trigger circuit (310) employed is one that has an electronic data processing equipment (EDPE) comprising the following components:

   - a first binary junction (AA) that emits a first binary signal (OUTA) and that is connected to the trigger output (AUS2) via a first feed line (Z1) in which a first intermediate resistor (RZ1) is interposed,
   - a second binary junction (AB) that emits a second binary signal (OUTB) and that is connected to the trigger output (AUS2) via a second feed line (Z2) in which a first diode (D1) and an intermediate resistor (RZ2) which is connected in series downstream from said first diode are interposed, wherein
   - the second intermediate resistor (RZ2) has a smaller value than the first intermediate resistor (RZ1),
   - and the anode of the first diode (D1) is connected to the second binary junction (AB) and the cathode of the first diode (D1) is connected to the second intermediate resistor (RZ2),
   - a third binary junction (AC) that emits a third binary signal (OUTC) and that is connected to a third feed line (Z3) branching off from the second feed line (Z2) between the first diode (D1) and the second intermediate resistor and having a second diode (D2) interconnected whose cathode is connected to the third binary junction (AC) and whose anode is connected to the cathode of the first diode (D1),

   wherein

   a) each of said first, second and third binary signals (OUTA, OUTB, OUTC) is either a high-signal or a low-signal or a time sequence of such signals,
   b) the first binary junction (AA) emits a high-signal if the frequency of the oscillator (112, 212) is smaller than the target frequency, and otherwise emits a low-signal, or vice versa, and
   c) the trigger circuit (310)

      - can be set into a first mode, fast mode, in which each of said second and third binary junctions (AB, AC)

         - emits a high-signal if the first binary junction (AA) emits a high-signal,
         - and emits a low-signal if the first binary junction (AA) emits a low-signal,

      so that the integrator (211, 211', 211A, 211B, 211C) is capable of integrating the trigger signal (OUT1) with a first time constant into the control voltage (Uc),
      - and can be set into a second mode, slow mode, in which the second binary junction (AB) always emits a low-signal and the third binary junction (AC) always emits a high-signal, so that the integrator (211, 211', 211A, 211B, 211C) is capable of integrating the trigger signal (OUT1) with a second time constant that is greater than the first time constant into the control voltage (Uc).

35. The method according to claim 34, **characterized in that**, said trigger circuit (310) is capable of automatically entering the fast mode upon a switch-on or reset, and then shifting into the slow mode

   - after a certain period of time has elapsed
   - or if the frequency of the oscillator (112, 212) comes below a predefined distance from the target frequency,
   - or if the frequency of the oscillator (112, 212) reaches a predefined frequency range.

**36.** The method according to one of claims 29 to 35, **characterized in that** either

- a non-inverting integrator (211A, 211B, 211C) that has an additional inverting integrator input to which a reference voltage (Uo) is applied,
- or an inverting integrator (211') that has an additonal non-inverting integrator input to which a reference voltage (Uo) is applied

is used as the integrator (211, 211', 211A, 211B, 211C).

**37.** The method according to claim 36, **characterized in that**
the reference voltage (Uo) that is applied to the additional integrator input is equal to the arithmetic mean of the first and second voltage values (U1, U2).

**38.** The method according to any of claims 31 to 34, **characterized in that**
the frequency of an alternating voltage, in particular the decay frequency of an ultrasonic transducer (16), is used as the target frequency.

**Revendications**

**1.** Circuit oscillateur avec un oscillateur (112, 212) comprenant une bascule avec une sortie (A) et une entrée inverseuse (E-), dans lequel

- la sortie (A) est reliée à l'entrée inverseuse (E-) via une résistance de réaction (RR),
- l'entrée inverseuse (E-) est mise à un premier potentiel via un premier oscillateur-condensateur (OC1),
- l'entrée inverseuse (E-) est mise en outre à un deuxième potentiel via un deuxième oscillateur-condensateur (OC2) et une résistance de commande (Rvar,RST,ST1,ST2,ST3,ST4) connecté en série avec celui-ci et dont la valeur est réglable ou commandable électriquement,

de sorte que la fréquence (f) de l'oscillateur (112, 212) peut être variée par modification de la valeur de la résistance de commande (Rvar,RST,ST1, ST2,ST3,ST4).

**2.** Circuit oscillateur selon la revendication 1, **caractérisé en ce que**

- la résistance de commande (ST1) est mise au deuxième potentiel non pas directement, mais via une source de tension intercalée, et/ou
- le premier oscillateur-condensateur (OC1) est mis au premier potentiel non pas directement, mais via une source de tension intercalée.

**3.** Circuit oscillateur selon l'une des revendications 1 ou 2, **caractérisé en ce que**
la résistance de commande (Rvar, RST) est constituée par le chemin collecteur-émetteur ou le chemin drain-source d'un transistor (ST1,ST2), transistor de commande (ST1, ST2), à la base ou à la grille duquel est appliquée une tension de commande (Uc), de sorte que

- le deuxième oscillateur-condensateur (OC2) est mis au deuxième potentiel, en particulier à la masse, via le chemin collecteur-émetteur ou le chemin drain-source du transistor de commande (ST1,ST2),
- et la fréquence (f) de l'oscillateur peut être variée par modification de la tension de commande (Uc).

**4.** Circuit oscillateur selon l'une des revendications 1 ou 2, **caractérisé en ce que**
la résistance de commande est constituée par le chemin collecteur-émetteur d'un transistor, transistor de commande, dont la base est parcourue par un courant de commande, de sorte que

- le deuxième oscillateur-condensateur est mis au deuxième potentiel, en particulier à la masse, via le chemin collecteur-émetteur du transistor de commande,
- et la fréquence de l'oscillateur peut être variée par modification du courant de commande.

**5.** Circuit oscillateur selon l'une des revendications 3 ou 4, **caractérisé en ce que**
le chemin collecteur-émetteur ou le chemin drain-source du transistor de commande (ST1,ST2) est intercalé inversement entre le deuxième oscillateur-condensateur (OC2) et le deuxième potentiel (Q2).

6. Circuit oscillateur selon l'une des revendications 1 ou 2, **caractérisé en ce que**
la résistance de commande (Rvar,RST) est constituée par le chemin collecteur-émetteur ou par le chemin drain-source d'un transistor (ST3,ST4), transistor de commande (ST3,ST4), à l'émetteur ou à la source duquel est appliquée une tension de commande (Uc) et dont la base ou la grille est mise à un troisième potentiel (Q"), de sorte que

- le deuxième oscillateur-condensateur (OC2) est connecté à la tension de commande (Uc) via le chemin collecteur-émetteur ou le chemin drain-source du transistor de commande, et le transistor de commande est connecté de ce fait en mode circuit base commune ou en mode montage grille commune,
- et la fréquence (f) de l'oscillateur (112, 212 peut être variée par modification de la tension de commande (Uc).

7. Circuit oscillateur selon l'une des revendications 1 à 6, **caractérisé en ce que**
la valeur de la résistance de commande (Rvar,RST,ST1,ST2,ST3,ST4) et par conséquent la fréquence de l'oscillateur (112,212) peuvent être influencées, commandées ou réglées à l'aide d'un signal 1 bit modulé, en particulier à l'aide d'une modulation de largeur d'impulsion.

8. Circuit oscillateur selon l'une des revendications 3, 5 ou 6 et selon la revendication 7, caractérisé e ce que
la tension de commande (Uc) et par conséquent la fréquence (f) de l'oscillateur (112, 212) peuvent être influencées, commandées ou réglées à l'aide d'un signal 1 bit modulé, en particulier à l'aide d'une modulation de largeur d'impulsion.

9. Circuit oscillateur selon la revendication 3 et l'une des revendications 7 ou 8, **caractérisé en ce que**
la base ou la grille du transistor de commande (ST1,ST2) est reliée à la sortie (IA) d'un intégrateur (211,211',211A, 211B,211C), dont l'entrée (IE,IE+,IE-) est reliée à la sortie de commande (AUS2,BA,BA') d'un circuit de commande (210,210',310),

- le circuit de commande (210,210',310) étant capable de délivrer, via la sortie de commande (AUS2,BA,BA'), un signal de commande (OUT1) à l'entrée (IE,IE+,IE-) de l'intégrateur (211,211',211A,211B,211C), lequel signal est ou bien égal ou inférieur à une première valeur de tension (U1) ou bien égal ou supérieur à une deuxième valeur de tension (U2), la première valeur de tension (U1) étant inférieure à la deuxième valeur de tension (U2), et l'intégrateur (211,211',211A,211B,211C) étant capable d'intégrer le signal de commande (OUT1) à la tension de commande (Uc) et de délivrer cette dernière à la base ou à la grille du transistor de commande (ST1,ST2) via la sortie (IA) de l'intégrateur,

de sorte que

- ou bien la tension de commande (Uc) diminue lorsque le signal de commande (OUT1) est égal ou inférieur à la première valeur de tension (U1) et la tension de commande augmente lorsque le signal de commande (OUT1) est égal ou supérieur à la deuxième valeur de tension (U2),
- ou vice-versa,

et que par conséquent la fréquence (f) de l'oscillateur (112,212) ou la vitesse de variation de ladite fréquence peut être influencée ou commandée par le signal de commande (OUT1).

10. Circuit oscillateur selon les revendications 8 et 9, **caractérisé en ce que** le signal de commande (OUT1) est un signal 1 bit modulé par impulsions qui alterne entre la première et la deuxième valeur de tension (U1,U2) essentiellement en forme rectangulaire, de sorte que

- ou bien la tension de commande (Uc) peut être diminuée en réduisant la valeur moyenne du signal de commande (OUT1) par variation de la séquence temporelle de la première et de la deuxième valeur de tension (U1,U2) et la tension de commande (Uc) peut être augmentée en augmentant la valeur moyenne du signal de commande (OUT1) par variation de la séquence temporelle de la première et de la deuxième valeur de tension (U1,U2),
- ou vice-versa,

et que par conséquent la fréquence (f) de l'oscillateur (112,212) ou la vitesse de variation de ladite fréquence peut être influencée ou commandée par le signal 1 bit modulé par impulsions.

**11.** Circuit oscillateur selon la revendication 10, **caractérisé en ce que** le signal de commande (OUT1) est un signal 1 bit modulé par impulsions qui alterne entre la première et la deuxième valeur de tension (U1,U2) essentiellement en forme rectangulaire avec un rapport cyclique variable, et dont la valeur moyenne peut être modifiée par variation du rapport cyclique, de sorte que le signal 1 bit modulé par impulsions destiné à influencer ou à commander la fréquence (f) ou sa vitesse de variation est un signal à modulation de largeur d'impulsions.

**12.** Circuit oscillateur selon l'une des revendications 9 à 11, **caractérisé en ce que**
le circuit de commande (210,210',310) présente une entrée (E1,E1') reliée à la sortie (A) de la bascule ou de la bascule de Schmitt (3) et est capable de détecter la fréquence (f) de l'oscillateur (112,212) par l'intermédiaire de l'entrée (E1,E1') et de l'influencer au moyen du signal de commande (OUT1) de sorte que la fréquence (f) de l'oscillateur (112,212) diminue lorsqu'elle est supérieure à une fréquence nominale prédéterminable (fsoll) et augmente, lorsqu'elle est inférieure à la fréquence nominale (fsoll), de sorte que l'oscillateur (112,212) est un oscillateur contrôlé.

**13.** Circuit oscillateur selon l'une des revendications 9 à 11 et selon la revendication 12, **caractérisé en ce que**
le circuit de commande (210,210',310) est capable de modifier la séquence temporelle de la première et de la deuxième valeur de tension (U1,U2) de sorte que

- la fréquence de l'oscillateur (112,212) diminue lorsque la fréquence de l'oscillateur (112,212) est supérieure à la fréquence nominale prédéterminable (fsoll),
- et la fréquence de l'oscillateur (112,212) augmente lorsque la fréquence de l'oscillateur (112,212) est inférieure à la fréquence nominale prédéterminable (fsoll),

de sorte que l'oscillateur (112,212) est un oscillateur contrôlé par l'intermédiaire d'une modulation d'impulsions.

**14.** Circuit d'oscillateur selon l'une des revendications 9 à 13, **caractérisé en ce que**
le circuit de commande (310) présente un équipement informatique (EDVE) comportant les composants suivants :

- une première connexion binaire (AA) qui émet un premier signal binaire (OUTA) et qui est reliée à la sortie de commande (AUS2) via une première ligne d'alimentation (Z1), dans laquelle est intercalée une première résistance intermédiaire (RZ1),
- une deuxième connexion binaire (AB) qui émet un deuxième signal binaire (OUTB) et qui est reliée à la sortie de commande (AUS2) via une deuxième ligne d'alimentation (Z2), dans laquelle sont intercalées une première diode (D1) et une deuxième résistance intermédiaire (RZ2) montée en série en aval de ladite diode,

- la deuxième résistance intermédiaire (RZ2) présentant une valeur inférieure à celle de la première résistance intermédiaire (RZ1),
- et l'anode de la première diode (D1) étant reliée à la deuxième connexion binaire (AB) et la cathode de la première diode (D1) étant reliée à la deuxième résistance intermédiaire (RZ2),

- une troisième connexion binaire (AC) qui émet un troisième signal binaire (OUTC) et qui est reliée à une troisième ligne d'alimentation (Z3) laquelle est dérivée à partir de la deuxième ligne d'alimentation (Z2) entre la première diode (D1) et la deuxième résistance intermédiaire, et dans laquelle est intercalée une deuxième diode (D2), dont la cathode est reliée à la troisième connexion binaire (AC) et dont l'anode est reliée à la cathode de la première diode (D1),

dans lequel

a) le premier, le deuxième et le troisième signal binaire (OUTA,OUTB,OUTC) sont respectivement un signal Haut ou un signal Bas ou une séquence temporelle de ceux-ci,
b) la première connexion binaire (AA) délivre un signal Haut, lorsque la fréquence (f) de l'oscillateur (112/212) est inférieure à la fréquence nominale, et, sinon, délivre un signal Bas ou vice-versa, et
c) le circuit de commande (310)

- peut être mis en un premier mode, mode rapide, dans lequel la deuxième et la troisième connexion binaire (AB,AC)

- délivrent chacune un signal Haut, lorsque la première connexion binaire (AA) émet un signal Haut

- et délivrent chacune un signal Bas, lorsque la première connexion binaire (AA) émet un signal Bas,

de sorte que l'intégrateur (211,211',211A,211 B,211C) est capable d'intégrer le signal de commande (OUT1) à la tension de commande (Uc) avec une première constante de temps,
- et peut être mis en un deuxième mode, mode lent, dans lequel la deuxième connexion binaire (AB) délivre toujours un signal Bas et la troisième connexion binaire (AC) délivre toujours un signal Haut, de sorte que l'intégrateur (211,211',211A,211B,211C) est capable d'intégrer le signal de commande (OUT1) à la tension de commande (Uc) avec une deuxième constante de temps qui est plus grande que la première constante de temps.

**15.** Circuit oscillateur selon l'une des revendications 12 à 14, **caractérisé en ce que**
le circuit de commande (310), après sa mise en circuit ou sa remise à zéro, est capable de se mettre lui-même d'abord en mode rapide et

- après un certain temps
- ou lorsque la fréquence de l'oscillateur (112,212) reste inférieure à une distance prédéterminée de la fréquence nominale,
- ou lorsque la fréquence de l'oscillateur (112,212) atteint une plage de fréquences prédéterminée,

est capable de se mettre lui-même en mode lent.

**16.** Circuit oscillateur selon l'une des revendications 9 à 15, **caractérisé en ce que**
l'intégrateur (211,211',211A,211B,211 C)

- est un intégrateur non inverseur (211 A,211B,211C) qui présente de plus une entrée d'intégrateur inverseuse à laquelle est appliquée une tension de référence (Uo),
- ou est un intégrateur inverseur (211') qui présente de plus une entrée d'intégrateur non inverseuse à laquelle est appliquée une tension de référence (Uo).

**17.** Circuit oscillateur selon la revendication 16, **caractérisé en ce que**
la tension de référence (Uo) est égale à la moyenne arithmétique de la première et de la deuxième valeur de tension (U1 ,U2).

**18.** Circuit oscillateur selon l'une des revendications 12 à 17, **caractérisé en ce que**
le circuit de commande (210) présente une entrée supplémentaire (E2) permettant de détecter la fréquence d'une tension alternative, en particulier la fréquence d'amortissement d'un transducteur à ultrasons (16) et de l'utiliser en tant que fréquence nominale (fsoll).

**19.** Circuit oscillateur selon l'une des revendications 1 à 18, **caractérisé en ce que**
le premier et le deuxième potentiel sont identiques l'un à l'autre.

**20.** Circuit oscillateur selon la revendication 19, **caractérisé en ce que** le premier potentiel et le deuxième potentiel sont identiques à la masse.

**21.** Procédé destiné à influencer, commander ou régler la fréquence d'un oscillateur (112,212), dans lequel

- on utilise comme oscillateur (112,212) un oscillateur comprenant une bascule (3) avec une sortie (A) et une entrée inverseuse (E-),
- la sortie (A) est reliée à l'entrée inverseuse (E-) via une résistance de réaction (RR),
- l'entrée inverseuse (E-) est mise à un premier potentiel via un premier oscillateur-condensateur (OC1),
- l'entrée inverseuse (E-) est mise en outre à un deuxième potentiel via un deuxième oscillateur-condensateur (OC2) et une résistance de commande (Rvar,RST,ST1,ST2,ST3,ST4) connecté en série avec celui-ci et dont la valeur est réglable ou commandable électriquement,
- et la fréquence (f) de l'oscillateur (112, 212) est variée par modification de la valeur de la résistance de commande (Rvar,RST,ST1, ST2,ST3,ST4).

**22.** Procédé selon la revendication 21, **caractérisé en ce que**

- on utilise comme résistance de commande (ST1,ST2) une résistance de commande mise au deuxième potentiel non pas directement, mais via une source de tension intercalée (Q), et/ou
- on utilise comme premier oscillateur-condensateur (OC1) un oscillateur-condensateur mis au premier potentiel non pas directement, mais via une source de tension intercalée.

23. Procédé selon l'une des revendications 21 ou 22, **caractérisé en ce que**

- on utilise comme résistance de commande (Rvar, RST) le chemin collecteur-émetteur ou le chemin drain-source d'un transistor (ST1,ST2), transistor de commande (ST1, ST2), de sorte que le deuxième oscillateur-condensateur (OC2) est mis au deuxième potentiel, en particulier à la masse, via le chemin collecteur-émetteur ou le chemin drain-source du transistor de commande ST1,ST2),
- une tension de commande (Uc) est appliquée à la base ou à la grille du transistor de commande (ST1,ST2),
- et la fréquence (f) de l'oscillateur est variée par modification de la tension de commande (Uc).

24. Procédé selon l'une des revendications 21 ou 22, **caractérisé en ce que**

- on utilise comme résistance de commande le chemin collecteur-émetteur d'un transistor, transistor de commande, dont la base est parcourue par un courant de commande, de sorte que le deuxième oscillateur-condensateur est mis au deuxième potentiel, en particulier à la masse, via le chemin collecteur-émetteur du transistor de commande,
- et la fréquence de l'oscillateur est variée par modification du courant de commande.

25. Circuit oscillateur selon l'une des revendications 23 ou 24, **caractérisé en ce que** le chemin collecteur-émetteur ou le chemin drain-source du transistor de commande (ST1,ST2) est exploité inversement.

26. Circuit oscillateur selon l'une des revendications 21 ou 22, **caractérisé en ce que** la résistance de commande (Rvar,RST) est constituée par le chemin collecteur-émetteur ou par le chemin drain-source d'un transistor (ST3,ST4), transistor de commande (ST3,ST4), à l'émetteur ou à la source duquel est appliquée une tension de commande (Uc) et dont la base ou la grille est mise à un troisième potentiel (Q''), de sorte que

- le deuxième oscillateur-condensateur (OC2) est mis au deuxième potentiel via le chemin collecteur-émetteur ou le chemin drain-source du transistor de commande, le transistor de commande étant exploité de ce fait en mode circuit base commune ou en mode montage grille commune,
- et la fréquence (f) de l'oscillateur (112, 212 est variée par modification de la tension de commande (Uc).

27. Procédé selon l'une des revendications 21 à 26, **caractérisé en ce que** la valeur de la résistance de commande (Rvar,RST,ST1,ST2,ST3,ST4) et par conséquent la fréquence de l'oscillateur (112,212) sont influencées, commandées ou réglées à l'aide d'un signal 1 bit modulé, en particulier à l'aide d'une modulation de largeur d'impulsion.

28. Procédé selon l'une des revendications 23 ou 26, caractérisé e ce que la tension de commande (Uc) et par conséquent la fréquence (f) de l'oscillateur (112, 212) sont influencées, commandées ou réglées à l'aide d'un signal 1 bit modulé, en particulier à l'aide d'une modulation de largeur d'impulsion.

29. Procédé selon l'une des revendications 23 à 28, **caractérisé en ce que** on utilise comme transistor de commande (ST1,ST2) un transistor de commande dont la base ou la grille est reliée à la sortie (IA) d'un intégrateur (211,211', 211A,211B,211C), dont l'entrée (IE,IE+,IE-) est reliée à la sortie de commande (AUS2,BA,BA') d'un circuit de commande (210,210',310), dans lequel

- le circuit de commande (210,210',310) utilisé est un circuit de commande capable de délivrer, via la sortie de commande (AUS2,BA,BA'), un signal de commande (OUT1) à l'entrée (IE,IE+,IE-) de l'intégrateur (211,211', 211A,211B,211 C), lequel signal est ou bien égal ou inférieur à une première valeur de tension (U1) ou bien égal ou supérieur à une deuxième valeur de tension (U2), la première valeur de tension (U1) étant inférieure à la deuxième valeur de tension (U2), et
- l'intégrateur (211,211',211A,211B,211C) utilisé est un intégrateur capable d'intégrer le signal de commande (OUT1) à la tension de commande (Uc) et de délivrer cette dernière à la base ou à la grille du transistor de commande (ST1,ST2) via la sortie (IA) de l'intégrateur,

et dans lequel

- ou bien la tension de commande (Uc) peut être diminuée en commandant le circuit de commande (210,210', 310) de sorte que le signal de commande (OUT1) est égal ou inférieur à la première valeur de tension (U1)
- et la tension de commande peut être augmentée en commandant le circuit de commande (210,210',310) de sorte que le signal de commande (OUT1) est égal ou supérieur à la deuxième valeur de tension (U2),

ou vice-versa, de sorte que la fréquence (f) de l'oscillateur (112,212) ou la vitesse de variation de ladite fréquence est influencée ou commandée par le signal de commande (OUT1).

**30.** Procédé selon les revendications 28 et 29, **caractérisé en ce que** le signal de commande (OUT1) utilisé est un signal 1 bit modulé par impulsions qui alterne entre la première et la deuxième valeur de tension (U1,U2) essentiellement en forme rectangulaire, de sorte que

- ou bien la tension de commande (Uc) peut être diminuée en réduisant la valeur moyenne du signal de commande (OUT1) par variation de la séquence temporelle de la première et de la deuxième valeur de tension (U1,U2) et la tension de commande (Uc) peut être augmentée en augmentant la valeur moyenne du signal de commande (OUT1) par variation de la séquence temporelle de la première et de la deuxième valeur de tension (U1,U2),
- ou vice-versa,

et que la fréquence (f) de l'oscillateur (112,212) ou la vitesse de variation de ladite fréquence est influencée ou commandée par le signal 1 bit modulé par impulsions.

**31.** Procédé selon la revendication 30, **caractérisé en ce que** le signal de commande (OUT1) utilisé est un signal 1 bit modulé par impulsions qui alterne entre la première et la deuxième valeur de tension (U1,U2) essentiellement en forme rectangulaire avec un rapport cyclique variable, et dont la valeur moyenne peut être modifiée par variation du rapport cyclique, de sorte que la fréquence (f) de l'oscillateur (112,212) ou la vitesse de variation de celle-ci est influencée ou commandée par une modulation de largeur d'impulsions.

**32.** Procédé selon l'une des revendications 29 à 31, **caractérisé en ce que**

- on utilise comme circuit de commande (210,210',310) un circuit présentant une entrée (E1,E1') reliée à la sortie (A) de la bascule ou de la bascule de Schmitt (3) et détectant la fréquence (f) de l'oscillateur (112,212),
- et la fréquence (f) de l'oscillateur (112,212) est influencée au moyen du signal de commande (OUT1) de sorte qu'elle diminue lorsqu'elle est supérieure à une fréquence nominale prédéterminable (fsoll) et augmente, lorsqu'elle est inférieure à la fréquence nominale (fsoll),

de sorte que la fréquence (f) de l'oscillateur (112,212) est réglée par l'intermédiaire du circuit de commande (210,210', 310).

**33.** Procédé selon l'une des revendications 29 à 31 et selon la revendication 32, **caractérisé en ce que** la séquence temporelle de la première et de la deuxième valeur de tension (U1,U2) est modifiée de sorte que

- la fréquence de l'oscillateur (112,212) diminue lorsque la fréquence de l'oscillateur (112,212) est supérieure à la fréquence nominale prédéterminable (fsoll),
- et la fréquence de l'oscillateur (112,212) augmente lorsque la fréquence de l'oscillateur (112,212) est inférieure à la fréquence nominale prédéterminable (fsoll),

de sorte que l'oscillateur (112,212) est réglé par l'intermédiaire d'une modulation d'impulsions.

**34.** Procédé selon l'une des revendications 29 à 33, **caractérisé en ce que** on utilise comme circuit de commande (310) un circuit présentant un équipement informatique (EDVE) comportant les composants suivants :

- une première connexion binaire (AA) qui émet un premier signal binaire (OUTA) et qui est reliée à la sortie de commande (AUS2) via une première ligne d'alimentation (Z1), dans laquelle est intercalée une première résistance intermédiaire (RZ1),
- une deuxième connexion binaire (AB) qui émet un deuxième signal binaire (OUTB) et qui est reliée à la sortie de commande (AUS2) via une deuxième ligne d'alimentation (Z2), dans laquelle sont intercalées une première diode (D1) et une deuxième résistance intermédiaire (RZ2) montée en série en aval de ladite diode,

- la deuxième résistance intermédiaire (RZ2) présentant une valeur inférieure à celle de la première résistance intermédiaire (RZ1),
- et l'anode de la première diode (D1) étant reliée à la deuxième connexion binaire (AB) et la cathode de la première diode (D1) étant reliée à la deuxième résistance intermédiaire (RZ2),

- une troisième connexion binaire (AC) qui émet un troisième signal binaire (OUTC) et qui est reliée à une troisième ligne d'alimentation (Z3) laquelle est dérivée à partir de la deuxième ligne d'alimentation (Z2) entre la première diode (D1) et la deuxième résistance intermédiaire, et dans laquelle est intercalée une deuxième diode (D2), dont la cathode est reliée à la troisième connexion binaire (AC) et dont l'anode est reliée à la cathode de la première diode (D1),

dans lequel

a) le premier, le deuxième et le troisième signal binaire (OUTA,OUTB,OUTC) sont respectivement un signal Haut ou un signal Bas ou une séquence temporelle de ceux-ci,
b) la première connexion binaire (AA) délivre un signal Haut, lorsque la fréquence (f) de l'oscillateur (112/212) est inférieure à la fréquence nominale, et, sinon, délivre un signal Bas ou vice-versa, et
c) le circuit de commande (310)

- peut être mis en un premier mode, mode rapide, dans lequel la deuxième et la troisième connexion binaire (AB,AC)

- délivrent chacune un signal Haut, lorsque la première connexion binaire (AA) émet un signal Haut
- et délivrent chacune un signal Bas, lorsque la première connexion binaire (AA) émet un signal Bas,

de sorte que l'intégrateur (211,211',211A,211B,211C) est capable d'intégrer le signal de commande (OUT1) à la tension de commande (Uc) avec une première constante de temps,
- et peut être mis en un deuxième mode, mode lent, dans lequel la deuxième connexion binaire (AB) délivre toujours un signal Bas et la troisième connexion binaire (AC) délivre toujours un signal Haut, de sorte que l'intégrateur (211,211',211A,211B,211C) est capable d'intégrer le signal de commande (OUT1) à la tension de commande (Uc) avec une deuxième constante de temps qui est plus grande que la première constante de temps.

**35.** Procédé selon la revendication 34, **caractérisé en ce que** le circuit de commande (310), après sa mise en circuit ou sa remise à zéro, est mis automatiquement d'abord en mode rapide et

- après un certain temps
- ou lorsque la fréquence de l'oscillateur (112,212) reste inférieure à une distance prédéterminée de la fréquence nominale,
- ou lorsque la fréquence de l'oscillateur (112,212) atteint une plage de fréquences prédéterminée,

est mis en mode lent.

**36.** Procédé selon l'une des revendications 29 à 35, **caractérisé en ce que** on utilise comme intégrateur (211,211', 211A.211B,211C)

- un intégrateur non inverseur (211 A,211B,211C) qui présente de plus une entrée d'intégrateur inverseuse à laquelle est appliquée une tension de référence (Uo),
- ou un intégrateur inverseur (211') qui présente de plus une entrée d'intégrateur non inverseuse à laquelle est appliquée une tension de référence (Uo).

**37.** Procédé selon la revendication 36, **caractérisé en ce que** on applique à l'entrée d'intégrateur supplémentaire une tension de référence (Uo) égale à la moyenne arithmétique de la première et de la deuxième valeur de tension (U1,U2).

**38.** Procédé selon l'une des revendications 31 à 34, **caractérisé en ce que** on utilise comme fréquence nominale la fréquence d'une tension alternative, en particulier la fréquence d'amortissement d'un transducteur à ultrasons (16).

Fig. 10

Fig. 11

Fig. 1

Fig. 9

EP 1 920 535 B1

Fig. 2

Fig. 3

41

Fig. 4

Fig. 5

Fig. 6

Fig. 8

Fig. 7

| OUT A | OUT B | OUT C | Modus |
|---|---|---|---|
| H | H | H | schnelle Integration Ansteuersignal OUT1 = H |
| L | L | L | schnelle Integration Ansteuersignal OUT1 = L |
| x | L | H | langsame Integration |
| x | H | L | verbotener Zustand |

Fig. 21

Fig. 12

**Fig. 13**

**Fig. 14**

**Fig. 15**

**Fig. 16**

**Fig. 17**

**Fig. 18**

**Fig. 19**

**Fig. 20**

**EP 1 920 535 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 3688220 A